# NEUE EUROPÄISCHE PATENTSCHRIFT

(11) **EP 3 262 432 B2**
(45) Veröffentlichungstag und Bekanntmachung des Hinweises auf die Entscheidung über den Einspruch: **19.01.2022**
(45) Hinweis auf die Patenterteilung: 30.01.2019
(21) Anmeldenummer: 16710087.4
(22) Anmeldetag: 24.02.2016
(51) Int. Cl.: G01R 33/09, G07D 7/04

(54) **VERFAHREN ZUR VORMAGNETISIERUNG MAGNETISCHER MATERIALIEN AUF EINEM MESSOBJEKT**
METHOD FOR BIASING OF MAGNETIC MATERIALS ON A MEASUREMENT OBJECT
PROCÉDÉ PERMETTANT DE POLARISER DES MATÉRIAUX MAGNÉTIQUES SUR UN OBJET DE MESURE

(30) Priorität: 24.02.2015 DE 102015002219
(43) Veröffentlichungstag der Anmeldung: 03.01.2018
(73) Patentinhaber: TE Connectivity Sensors Germany GmbH, 44227 Dortmund (DE)
(72) Erfinder: BARTOS, Axel, 45731 Waltrop (DE); MEISENBERG, Armin, 44227 Dortmund (DE)
(74) Vertreter: Tilmann, Max Wilhelm
(86) Internationale Anmeldenummer: PCT/EP2016/000315
(87) Internationale Veröffentlichungsnummer: WO 2016/134849

(56) Entgegenhaltungen:
- EP-B1- 1 770 657
- WO-A1-2006/042667
- WO-A1-2010/066779
- WO-A1-2011/026829
- WO-A1-2011/154088
- WO-A1-2013/087168
- WO-A1-2014/168180
- WO-A1-2015/090545
- WO-A2-2013/023781
- DE-A1-102011 110 138
- DE-A1-102012 024 175
- US-A- 4 536 230
- US-A1- 2006 279 280
- US-B1- 6 310 475

## Beschreibung

Die Erfindung betrifft ein Verfahren zur Vormagnetisierung magnetischer Materialien auf einem Messobjekt mit einem ersten magnetischen Material mit einer ersten Koerzitivfeldstärke und einem zweiten magnetischen Material mit einer zweiten Koerzitivfeldstärke, die niedriger ist als die erste Koerzitivfeldstärke, wobei das Messobjekt nach der Vormagnetisierung einer Sensorzeile einer Messvorrichtung zum Messen magnetischer Eigenschaften der Umgebung der Messvorrichtung zugeführt wird.

Ein mögliches Anwendungsgebiet der Erfindung ist das Prüfen von Scheinen oder Bögen, insbesondere von Geldscheinen, Schecks oder anderen Papierbögen auf das Vorhandensein magnetischer Merkmale, insbesondere daraufhin, ob die Scheine oder Bögen besondere, vorher festgelegte magnetische Merkmale aufweisen.

Wertdokumente können weichmagnetische Sicherheitsmerkmale und/oder hartmagnetische Sicherheitsmerkmale aufweisen. Hartmagnetische Sicherheitsmerkmale können aus Werkstoffen mit hoher Remanenz und hoher Koerzitivfeldstärke hergestellt werden. Weichmagnetische Sicherheitsmerkmale können aus Werkstoffen mit hoher Remanenz aber geringer Koerzitivfeldstärke hergestellt werden.

Permanentmagneten sind insbesondere aus hartmagnetischen Werkstoffen hergestellt. Weichmagnetische Werkstoffe sind ferromagnetische Materialien, die sich in einem Magnetfeld leicht magnetisieren lassen. Die damit verbundene magnetische Polarisation (Magnetisierung) kann z. B. durch einen elektrischen Strom in einer stromdurchflossenen Spule oder durch Anwesenheit eines Permanentmagneten erzeugt werden. Eine so erzeugte Polarisation führt in dem weichmagnetischen Werkstoff zu einer vielfach höheren magnetischen Flussdichte als das von außen wirkende magnetische Feld in der Luft erzeugt. Weichmagnetische Werkstoffe besitzen in der Regel eine Koerzitivfeldstärke von weniger als 1000 A/m. Weichmagnetische Werkstoffe können allerdings durchaus zu hartmagnetischen Werkstoffen vergleichbare Sättigungsmagnetisierungswerte besitzen, sodass sie im gesättigten Zustand von hartmagnetischen Materialien nicht zu unterscheiden sind.

Von hartmagnetischen Sicherheitsmerkmalen geht von sich aus und ohne Anwesenheit eines externen Magnetfelds ein Magnetfeld aus, sofern die hartmagnetischen Materialien zuvor vollständig und eindeutig magnetisiert wurden. Dieses Magnetfeld bleibt auch über längere Zeit bestehen. Über die Zeit führen aber statistische Prozesse dazu, dass die hartmagnetischen Materialien entmagnetisiert werden können. Beispielsweise erfahren Geldscheine bei ihrer Handhabung häufig Stöße oder werden geknittert. Dies kann zu einer Entmagnetisierung der hartmagnetischen Materialien führen. Deshalb ist es zum Messen hartmagnetischer Sicherheitsmerkmale zweckmäßig, durch einen Vormagnetisierungsmagneten dem hartmagnetischen Sicherheitsmerkmal eine neue (eindeutige und dauerhafte) Magnetisierung aufzuprägen. Diese neu aufgeprägte Magnetisierung kann das hartmagnetische Sicherheitsmerkmal dann über eine größere Zeitspanne, mindestens über dem Zeitraum der Messung, halten.

Ein besonderes Sicherheitsmerkmal auf Banknoten ist der ferromagnetische Sicherheitsfaden (siehe DE 16 96 245 A1). In der Praxis kommen zur Bildung des Sicherheitsfadens beispielsweise ferromagnetische Materialien zum Einsatz, die aber sowohl eine geringe Koerzitivfeldstärke als auch eine große Koerzitivfeldstärke aufweisen können. Messvorrichtungen zum Prüfen derartiger Banknoten sind in besonders bevorzugter Ausführungsform deshalb dafür ausgelegt, sowohl Sicherheitsfäden aus Material mit geringer, als auch Sicherheitsfäden aus Material mit großer Koerzitivfeldstärke zu erkennen.

Aus WO 2010/006801 A1 ist eine Messvorrichtung zum Messen magnetischer Eigenschaften der Umgebung der Messvorrichtung mit einer Sensorzeile aus mindestens zwei in einer sich in eine Zeilenrichtung erstreckenden Zeile angeordneten magnetoresistiven Sensorelementen und einer Stützfeldvorrichtung bekannt, die ein magnetisches Stützfeld erzeugt, das eine in Zeilenrichtung weisende Magnetfeldkomponente aufweist, deren Feldstärke in Zeilenrichtung variiert, wobei dieser Feldstärkenverlauf in Zeilenrichtung an zumindest zwei in Zeilenrichtung nacheinander angeordneten Sensorrändern der die Sensorzeile bildenden Sensorelemente keinen Nulldurchgang und/oder kein Maximum oder Minimum aufweist. Bei der dort beschriebenen Messvorrichtung kann in einer bevorzugten Ausführungsform ein Vormagnetisierungsmagnet vorgesehen sein, der vor der Sensorzeile angeordnet ist. Mit diesem Vormagnetisierungsmagnet kann eine Magnetisierung eines Messobjekts mit hartmagnetischem Muster erfolgen, über den das Messobjekt zunächst geführt wird. Wird das Messobjekt anschließend über eine Sensorzeile geführt, so kann diese Sensorzeile das hartmagnetische Muster erkennen.

Bei der aus WO 2010/006801 A1 bekannten Messvorrichtung können in einer bevorzugten Ausführungsform zwei in Leserichtung der zu messenden Objekte nacheinander angeordnete Sensorzeilen vorgesehen sein, die zur Ermittlung unterschiedlicher Merkmale eingesetzt werden. Dort geht man von dem Gedanken aus, dass zur Erkennung der magnetischen Muster eine Vormagnetisierung des Geldscheins notwendig ist, die ausschließlich das hartmagnetische Muster erkennende Sensorzeile jedoch während der Messung kein Vormagnetisierungsfeld aufweisen darf, während zur Erkennung der weichmagnetischen Muster ein starkes Vormagnetisierungsfeld für die Sensorzeile am Ort der Messung notwendig ist. Bei der dort beschriebenen Ausführungsform können hartmagnetische und weichmagnetische Muster dadurch erkannt werden, dass das Vormagnetisierungsfeld im Bereich einer ersten Sensorzeile wirkt und die magnetischen Merkmale nahezu vollständig aufmagnetisiert und die Erkennung der weich- und hartmagnetischen Muster ermöglicht und zugleich der Vormagnetisierung der hartmagnetischen Strukturen dient. Wird der Geldschein anschließend über eine zweite Sensorzeile geführt, in deren Bereich das Vormagnetisierungsfeld nicht mehr wirkt, so kann diese zweite Sensorzeile separat das rein hartmagnetische Muster erkennen.

Aus EP 0 977 015 B1 ist eine Messvorrichtung zum Messen magnetischer Eigenschaften der Umgebung der Messvorrichtung bekannt. Bei dieser Messvorrichtung ist ein Messelement (magnetism detecting element) vorgesehen und ein Stützfeldmagnet (bias magnet). Ferner ist bei der dort bekannten Vorrichtung ein Vormagnetisierungsmagnet in Form des Magneten 12 (Fig. 4) vorgesehen. Wie in [0042] und [0043] der EP 0 977 015 B1 beschrieben, muss das magnetische Material auf dem Wertdokument magnetisiert werden, bevor es erkannt werden soll. Hierzu wird ein Vormagnetisierungsmagnet in Form des Magneten 12 in der EP 0 977 015 B1 vorgesehen.

DE 10 2011 110 138 A1 betrifft eine Messvorrichtung zum Messen magnetischer Eigenschaften der Umgebung der Messvorrichtung.

US 2006/279280 A1 betrifft einen langen magnetischen Sensor.

DE 10 2012 024 175 A1 beschreibt ein Verfahren zur Untersuchung eines Sicherheitselements eines Wertdokuments, wobei wenigstens eine optische Eigenschaft des Sicherheitselements durch ein Magnetfeld beeinflussbar ist, bei dem das Wertdokument durch ein Magnetfeld, das quer zur Transportrichtung inhomogen ist und/oder zeitabhängig geändert wird, transportiert wird, ein Bild wenigstens eines Abschnitts des Wertdokuments mit dem Sicherheitselement erfasst wird und das Bild beschreibende Bilddaten gebildet werden, wobei die optischen Eigenschaften des Sicherheitselements durch das Magnetfeld beeinflusst sind, und geprüft wird, ob die Bilddaten, die einen das Sicherheitselement zeigenden Bildbereich beschreiben, eine der Ortsabhängigkeit des Magnetfeldes entsprechende Ortsabhängigkeit quer zur Transportrichtung und/oder eine der Zeitabhängigkeit des Magnetfeldes entsprechende Ortsabhängigkeit in Transportrichtung aufweisen. Weiter ist eine Vorrichtung zur Durchführung des Verfahrens beschrieben.

US 6,310,475 B1 betrifft einen magnetischen Sensor, der magnetische Detektoren aufweist, wobei die magnetischen Detektoren in einer Richtung angeordnet sind, die orthogonal zu einer relativen Bewegungsrichtung ist. Aus WO 2013/020702A1 ist ein Verfahren nach dem Oberbegriff des Anspruchs 1 bekannt.

Es sind nun Wertdokumente eingeführt worden, die mehrere hartmagnetische Sicherheitsmerkmale aufweisen, bei denen das eine hartmagnetische Sicherheitsmerkmal aus einem ersten magnetischen Material mit einer ersten Koerzitivfeldstärke und ein zweites Sicherheitsmerkmal aus einem zweiten magnetischen Material mit einer zweiten Koerzitivfeldstärke besteht. Ferner sind Wertdokumente eingeführt worden, die kombinierte Sicherheitsmerkmale haben, die durch eng beieinander angeordnetes Material hoher Koerzitivfeldstärke neben einem Material mit niedriger Koerzitivfeldstärke herstellt werden (kombiniertes Sicherheitsmerkmal). Das Vorhandensein der Sicherheitsmerkmale lässt sich bei derartigen Wertdokumenten mit einer Messvorrichtung feststellen, die in Laufrichtung des Wertdokuments mehrere Sensorzeilen und mehrere Vormagnetisierungsmagneten aufweist. Mit einem ersten Vormagnetisierungsmagneten können alle Sicherheitsmerkmale in eine gleiche Richtung vormagnetisiert werden. Dadurch lässt sich mit einer Messvorrichtung zunächst feststellen, ob das zu untersuchende Wertdokument die vollständige Anzahl aller festzustellenden Sicherheitsmerkmale aufweist. Wird dann in einer nachfolgenden Messvorrichtung mit einem zweiten Vormagnetisierungsmagneten, der ein schwächeres Feld erzeugt als der erste Vormagnetisierungsmagnet, das Wertdokument so vormagnetisiert, dass das Sicherheitsmerkmal mit dem niedrigkoerzitiven Material in die entgegengesetzte Richtung magnetisiert wird, so lässt sich in einer nachfolgenden Sensorzeile feststellen, welche Sicherheitsmerkmale hochkoerzitiv waren und wo diese auf dem Wertdokument liegen. Die Sicherheitsmerkmale aus hochkoerzitivem Material sind nach wie vor durch die ursprüngliche Vormagnetisierung in die erste Richtung vormagnetisiert und können von der Sensorzeile erkannt werden. Die Sicherheitsmerkmale mit niedrigkoerzitivem Material oder die kombinierten Sicherheitsmerkmale werden ummagnetisiert bzw. heben sich in ihrer Magnetisierung gegenseitig auf (kombiniertes Sicherheitsmerkmal, bei dem die hochkoerzitive Materialkomponente nach wie vor in die erste Richtung und die niedrigkoerzitive Materialkomponente mittlerweile in die gegenüberliegende Richtung magnetisiert wurde, sodass sich das kombinierte Feld stark abschwächt). Diese Sicherheitsmerkmale können durch die zweite Sensorzeile nicht direkt erkannt werden. Durch den Vergleich des Messergebnisses der ersten Sensorzeile (absolute Anzahl der auf dem Wertdokument vorhandenen Sicherheitsmerkmale) und der Messergebnisse der zweiten Sensorzeile (Anzahl und Ort der Sicherheitsmerkmale aus hochkoerzitivem Material) lässt sich bei einer solchen Messanordnung feststellen, welche der Sicherheitsmerkmale auf dem Wertdokument aus einem hochkoerzitiven Material und welche aus einem niedrigkoerzitiven Material sind. Zudem ergibt sich bei dieser Vorgehensweise ein Aufbau einer Messvorrichtung, der in Laufrichtung des Wertdokuments sehr lang ist. In der Mehrzahl der Anwendungsgebiete, insbesondere in Geldautomaten ist jedoch regelmäßig wenig Platz für eine Messvorrichtung mit einem Vormagnetisierungsmagneten und einer doppelzeiligen Sensorzeile.

Vor diesem Hintergrund lag der Erfindung die Aufgabe zugrunde, eine Messvorrichtung zu schaffen, die auf einem Wertdokumenten Sicherheitsmerkmale aus hochkoerzitivem Material und aus niedrigkoerzitivem Material gut erkennen kann.

Diese Aufgabe wird durch das Verfahren gemäß Anspruch 1 gelöst. Vorteilhafte Ausführungsformen sind in den Unteransprüchen und der hiernach folgenden Beschreibung wiedergegeben.

Die Erfindung geht von dem Grundgedanken aus, einen Vormagnetisierungsmagneten einzusetzen, dessen Magnetisierung nicht homogen ist. Eine nicht-homogene (inhomogene) Magnetisierung des Vormagnetisierungsmagneten bewirkt, dass das von dem Vormagnetisierungsmagneten erzeugte Magnetfeld sich in seiner Richtung und/oder in seiner Stärke in einer Ebene, durch die das zu untersuchende Messobjekt geführt werden kann, ändert, insbesondere bevorzugt kontinuierlich ändert. Insbesondere bevorzugt führt die nicht-homogene Magnetisierung zu einer Konzentration des von ihm erzeugten Magnetfelds in bestimmten Bereichen der Umgebung des Vormagnetisierungsmagneten. Unterschreitet ein an einem hartmagnetischen Material anliegendes Magnetfeld die Koerzitivfeldstärke des hartmagnetischen Materials, so friert die Magnetisierung dieses hartmagnetischen Materials in der Richtung ein, in der das von außen angelegte Feld zum Zeitpunkt des Unterschreitens der Koerzitivfeldstärke gerichtet war. Das bedeutet, dass die Magnetisierung hartmagnetischer Sicherheitsmerkmale mit unterschiedlichen Koerzitivfeldstärken an unterschiedlichen Stellen entlang der Bewegung des Messobjekts durch das von dem Vormagnetisierungsmagneten erzeugte Magnetfeld einfriert. Das besondere Magnetfeld eines Vormagnetisierungsmagneten mit einer nicht-homogenen Magnetisierung bewirkt, dass das von dem Vormagnetisierungsmagneten erzeugte Magnetfeld bei unterschiedlichen Feldstärken in unterschiedliche Richtungen weist. Dadurch wird es möglich, dem höherkoerzitiven Material eines ersten Sicherheitsmerkmals eine erste Magnetisierungsrichtung aufzuprägen, während einem geringer koerzitiven Material eine davon unterschiedliche Magnetisierungsrichtung aufgeprägt werden kann. Verwendet man in Kombination mit einem derartigen Vormagnetisierungsmagneten eine Sensorzeile, die für unterschiedliche Magnetisierungswinkel unterschiedliche Signalkurvenformen erzeugt, so wird es damit möglich, die unterschiedlich koerzitiven Materialien auf einem Messobjekt eindeutig zu identifizieren, wenn diese Materialien durch den Vormagnetisierungsmagneten magnetisiert wurden. Auch wird es mit einem derartigen Vormagnetisierungsmagneten möglich, ein Sicherheitsmerkmal aus kombiniertem Material zu identifizieren. Sind die Magnetisierungsrichtungen zum Zeitpunkt des Einfrierens der Magnetisierung des jeweiligen Materials (zum Zeitpunkt des Unterschreitens der Koerzitivfeldstärke des jeweiligen Materials) so gewählt, dass sie nicht um 180° zueinander versetzt weisen, so hebt sich die Magnetisierung bei einem kombinierten Sicherheitsmerkmal nicht auf, sodass auch das kombinierte Sicherheitsmerkmal durch die Sensorzeile identifiziert werden kann.

Die Erfindung ist insbesondere darauf gerichtet, für eine Messvorrichtung zum Messen magnetischer Eigenschaften der Umgebung der Messvorrichtung mit einer Sensorzeile mit mindestens einem sich in eine Zeilenrichtung erstreckenden magnetoresistiven Sensorelement, das magnetische Eigenschaften in seiner Umgebung messen kann, einen besonderen Vormagnetisierungsmagneten vorzuschlagen. Als Vormagnetisierungsmagnet wird im Kontext der vorliegenden Anmeldung insbesondere ein Magnet verstanden, der das hartmagnetische Material von Sicherheitsmerkmalen auf Wertpapieren magnetisieren kann. Die bei Wertdokumenten, insbesondere bei Geldscheinen bisher verwendeten hartmagnetischen Materialien für Sicherheitsmerkmale lassen sich in der Regel mit einem magnetischen Feld mit einer Feldstärke von kleiner 100 kA/m, typisch 50 kA/m magnetisiert. Als Vormagnetisierungsmagnet wird somit insbesondere ein Magnet verstanden, der in einer Ebene seiner Umgebung, durch die ein Messobjekt geführt werden könnte, zumindest an einem Punkt ein magnetisches Feld mit dieser Stärke erzeugt. Bei aus dem Stand der Technik bekannten Messvorrichtungen sind teilweise neben dem Vormagnetisierungsmagneten, dessen Aufgabe es ist, die hartmagnetischen Sicherheitsmerkmale für die Messung zu magnetisieren, Stützfeldmagneten vorgesehen, deren alleinige Aufgabe es ist, bei der Verwendung von magnetoresistiven Sensoren einer besonderen Art in der Sensorzeile ein Stützfeld für diese Art von Sensoren zu erzeugen. Vormagnetisierungsmagneten unterscheiden sich von diesen Stützfeldmagneten in der Regel dadurch, dass das von ihnen erzeugte Vormagnetisierungsfeld mehr als viermal stärker ist, als das von der Stützfeldvorrichtung erzeugte magnetische Feld. In einer bevorzugten Ausführungsform liegt ein wesentlicher Unterschied zwischen dem Vormagnetisierfeld und dem von der Stützfeldvorrichtung erzeugten magnetischen Feld in der Wirkrichtung. Ferner werden bei Messvorrichtungen mit Vormagnetisierungsmagnet und Stützfeldmagnet häufig Maßnahmen getroffen, um das von dem Vormagnetisierungsmagneten erzeugte Magnetfeld von der Sensorzeile abzuschirmen, wie beispielsweise das "magnetic shielding member 22" in EP 0 977 015 B1.

Der Vormagnetisierungsmagnet zeichnet sich dadurch aus, dass seine Magnetisierung nicht homogen ist. Unter dem Begriff "homogen" wird im Rahmen dieser Erfindung zur Charakterisierung der Magnetisierung des Vormagnetisierungsmagneten nicht eine beispielsweise bei Stabmagneten im Bereich der Oberfläche oder an Kanten auftretende, leichte Abweichung der Magnetisierung des Stabmagneten von der sonst durchgängig von einem Ende zum anderen Ende weisenden Magnetisierung des Stabmagneten verstanden. Unter einer nicht-homogenen Magnetisierung wird beispielsweise eine solche gesehen, bei der sich die Magnetisierung von einer Oberfläche des Vormagnetisierungsmagneten zur gegenüberliegenden Oberfläche des Vormagnetisierungsmagneten um mehr als 45°, insbesondere bevorzugt um mehr als 90°, insbesondere bevorzugt um mehr als 180° dreht. Als nicht-homogene Magnetisierung des Vormagnetisierungsmagneten wird insbesondere eine solche Magnetisierung verstanden, wie sie sich bei einem Halbach-Array einstellt. Ein Halbach-Array setzt sich aus Segmenten von Permanentmagneten zusammen, deren Magnetisierungsrichtung gegeneinander um jeweils 90° in Richtung der Längsachse des Arrays gekippt ist. Dadurch rücken die Feldlinien auf der Seite, in deren Richtung der Direktor des Felds gekippt wird, enger zusammen, was eine Erhöhung der magnetischen Flussdichte bewirkt. Auf der gegenüberliegenden Seite liegen die Feldlinien weniger eng als im ungestörten Magneten, daher wird das Feld schon in geringem Abstand abgeschwächt, bzw. verschwindet völlig, da sich Nord- und Südpole jeweils abwechseln. Die Vormagnetisierungsmagnete der Erfindung sind jedoch nicht auf solche beschränkt, bei denen die Magnetisierungsrichtung der einzelnen Permanentmagnete jeweils um 90° in Richtung der Längsachse des Arrays gekippt ist. Die nicht-homogene Magnetisierung des Vormagnetisierungsmagneten kann bei einer Ausführungsform mit miteinander verbundenen Permanentmagneten auch dadurch erreicht werden, dass deren Magnetisierungsrichtungen in anderen, beispielsweise kleineren oder auch größeren Winkeln als 90° zueinander stehen. Halbach-Magnete (Halbach-Arrays) werden des Weiteren in "Design of permanent multipole magnets with oriented rare earth cobalt material" von K. Halbach in Nuclear instruments and methods 169 (1980), 1-10, beschrieben oder in "Permanent magnet undulators", K. Halbach, Journal de Physique, 1983, 44 (C1), pp. C1-211, C1-216, oder in "Physical and optical properties of rare earth cobalt magnets", K. Halbach, Nuclear instruments and methods 187 (1981) 109-117).

Die geforderte nicht-homogene Magnetisierung des Vormagnetisierungsmagneten soll sich - wie beispielsweise bei einem Halbach-Array - in dem Festkörper des Vormagnetisierungsmagneten einstellen. Mit einer nicht-homogenen Magnetisierung des Vormagnetisierungsmagneten ist nicht die Magnetisierung verstanden, wie sie sich bei einem Hufeisenmagneten einstellt, bei dem die Magnetisierungsrichtung des einen Strangs im Verhältnis zur Magnetisierung des gegenüberliegenden Strangs um 180° gedreht ist, sodass man in allgemeinster Form davon sprechen könnte, dass die Magnetisierung eines Hufeisenmagneten nicht homogen ist. Diese Nicht-Homogenität der Magnetisierung eines Hufeisenmagneten stellt sich jedoch dadurch ein, dass die Magnetisierung zweier, durch einen Freiraum deutlich voneinander getrennter Stränge des Magneten unterschiedlich sind. Auch bei einem Hufeisenmagneten ist innerhalb des jeweiligen Strangs (innerhalb des jeweiligen Festkörperabschnitts) die Magnetisierung homogen. Für den Vormagnetisierungsmagneten wird gefordert, dass die Magnetisierung innerhalb des jeweiligen Festkörpers nicht homogen ist.

In einer bevorzugten Ausführungsform ist der Vormagnetisierungsmagnet so ausgebildet, dass
- der Verlauf der in eine erste Richtung weisenden Komponente der Magnetisierung des Vormagnetisierungsmagneten über die Erstreckung des Vormagnetisierungsmagneten in diese erste Richtung nicht homogen ist, und
- der Verlauf der in eine zweite, senkrecht zur ersten weisenden Richtung weisenden Komponente der Magnetisierung des Vormagnetisierungsmagneten über die Erstreckung des Vormagnetisierungsmagneten in diese zweite Richtung nicht homogen ist, und
- der Verlauf der in eine dritte, senkrecht sowohl zur ersten als auch senkrecht zur zweiten Richtung weisenden Komponente der Magnetisierung des Vormagnetisierungsmagneten über die Erstreckung des Vormagnetisierungsmagneten in diese dritte Richtung homogen ist.

Es hat sich gezeigt, dass die Inhomogenität der Magnetisierung des Vormagnetisierungsmagneten nur bezüglich einer Ebene eingestellt werden muss, während die Inhomogenität in eine dritte Richtung nicht zwingend notwendig ist. Dabei wird unter dem homogenen Verlauf der in eine dritte Richtung weisenden Komponente der Magnetisierung des Vormagnetisierungsmagneten über die Erstreckung des Vormagnetisierungsmagneten in diese dritte Richtung, auch eine solche Magnetisierung verstanden, bei der die in die dritte Richtung weisende Komponente im Wesentlichen 0 ist, die Magnetisierung des Vormagnetisierungsmagnet also nur in die erste und in die zweite Richtung eine Komponente aufweist.

In einer bevorzugten Ausführungsform weist der Vormagnetisierungsmagnet eine Höhe, eine Breite und eine Länge auf, wobei die Länge größer ist als die Höhe und größer ist als die Breite und die erste Richtung in Richtung der Höhe, die zweite Richtung in Richtung der Breite und die dritte Richtung in Richtung der Länge des Vormagnetisierungsmagneten weist. Insbesondere bei Messvorrichtungen zum Prüfen von Wertdokumenten, insbesondere bevorzugt von Geldscheinen, werden als Vormagnetisierungsmagnete stabförmige, bzw. allgemein gesprochen, als Langkörper ausgeführte Magnete verwendet. Es hat sich gezeigt, dass die Inhomogenität der Magnetisierung vor allem in Richtung der Höhe und in Richtung der Breite benötigt wird, weniger jedoch in Richtung der Längserstreckung eines solchen Vormagnetisierungsmagneten. Insbesondere bevorzugt ist bei einem stabförmigen Vormagnetisierungsmagneten die Magnetfeldkomponente in Richtung der Länge des Vormagnetisierungsmagneten im Wesentlichen 0.

In einer bevorzugten Ausführungsform weist der Vormagnetisierungsmagnet einen ersten Magneten und einen zweiten Magneten auf, die zur Bildung des Vormagnetisierungsmagneten miteinander verbunden sind, wobei Verlauf der Magnetisierungskomponente der Magnetisierung des ersten Magneten in die erste Richtung homogen ist und der Verlauf der Magnetisierungskomponente der Magnetisierung des ersten Magneten in die zweite Richtung homogen ist und der Verlauf der Magnetisierungskomponente der Magnetisierung des ersten Magneten in die dritte Richtung homogen ist, und der Verlauf der Magnetisierungskomponente der Magnetisierung des zweiten Magneten in die erste Richtung homogen ist und der Verlauf der Magnetisierungskomponente der Magnetisierung des zweiten Magneten in die zweite Richtung homogen ist und der Verlauf der Magnetisierungskomponente der Magnetisierung des zweiten Magneten in die dritte Richtung homogen ist, und wobei
- der Verlauf der Magnetisierungskomponente des ersten Magneten in die erste Richtung unterschiedlich ist zum Verlauf der Magnetisierungskomponente des zweiten Magneten in die erste Richtung und/oder
- der Verlauf der Magnetisierungskomponente des ersten Magneten in die zweite Richtung unterschiedlich ist zum Verlauf der Magnetisierungskomponente des zweiten Magneten in die zweite Richtung und/oder
- der Verlauf der Magnetisierungskomponente des ersten Magneten in die dritte Richtung unterschiedlich ist zum Verlauf der Magnetisierungskomponente des zweiten Magneten in die dritte Richtung.

Mit einer derartigen Anordnung lassen sich komplexe Formen von Halbach-Arrays erreichen, bei denen die Permanentmagneten nicht zwingend Magnetisierungen aufweisen müssen, die im Winkel von 90° zueinander stehen.

Der erste Magnet und der zweite Magnet können Stabmagneten sein, deren Magnetisierung in Höhenrichtung und/oder Breitenrichtung verläuft. Insbesondere bevorzugt ist die Magnetisierungskomponente in Längsrichtung im Wesentlichen null.

Die Verbindung des den Vormagnetisierungsmagneten bildenden ersten Magneten mit dem zweiten Magneten kann durch Kleben erfolgen, in dem der erste Magnet beispielsweise an den zweiten Magnet geklebt wird. Auch ist es denkbar den ersten Magnet und den zweiten Magnet zur Bildung des Vormagnetisierungsmagneten durch Einbetten in eine Gussmasse miteinander zu verbinden. Auch ist es denkbar den ersten Magnet und den zweiten Magnet zur Bildung des Vormagnetisierungsmagneten durch Einpressen in ein Gehäuse miteinander zu verbinden. Auch ist es denkbar den ersten Magnet und den zweiten Magnet zur Bildung des Vormagnetisierungsmagneten durch Einpressen in einen Rahmen oder sonstige Form formschlüssig miteinander zu verbinden.

In einer bevorzugten Ausführungsform ist der Verlauf der Magnetisierungskomponente des ersten Magneten in die dritte Richtung gleich zum Verlauf der Magnetisierungskomponente in die dritte Richtung. Hierdurch lässt sich die in einer bevorzugten Ausführungsform bestehende Forderung erreichen, dass die Magnetisierungskomponente in die dritte Richtung homogen verläuft, bzw. 0 ist. Dies lässt sich insbesondere dadurch erreichen, dass die Magnetisierungskomponente des ersten Magneten in die dritte Richtung 0 ist und die Magnetisierungskomponente des zweiten Magneten in die dritte Richtung 0 ist.

Im Vorstehenden wurden auch Ausführungsformen der Erfindung beschrieben, bei der der Vormagnetisierungsmagnet aus einem ersten und einem zweiten Material zusammengesetzt wird. Wie auch sonst bei Halbach-Arrays möglich, kann der Vormagnetisierungsmagnet auch aus einer Mehrzahl von Einzelkomponenten zusammengefügt werden, also beispielsweise durch das Zusammenfügen von drei, vier, fünf oder mehr Permanentmagneten.

Die Messvorrichtung zum Messen magnetischer Eigenschaften der Umgebung der Messvorrichtung weist mindestens eine Sensorzeile mit mindestens einem sich in eine Zeilenrichtung erstreckenden magnetoresistiven Sensorelement auf, das magnetische Eigenschaften in seiner Umgebung messen kann. Die Messvorrichtung weist mindestens einen Vormagnetisierungsmagneten auf.

Als Werkstoffe für den Vormagnetisierungsmagneten werden insbesondere bevorzugt isotrope Hartferrite und Seltene Erden enthaltende Magnete eingesetzt.

In einer bevorzugten Ausführungsform weist das von dem Vormagnetisierungsmagneten erzeugte Magnetfeld an einem ersten Ort einer Ebene eine erste Magnetfeldstärke und eine erste Magnetfeldrichtung auf und an einem zweiten Ort der Ebene eine zweite Magnetfeldstärke, die geringer ist als die erste Magnetfeldstärke, und eine zweite Magnetfeldrichtung, die von der ersten Magnetfeldrichtung um einen Differenzwinkel von ungleich 180° verschieden ist, insbesondere bevorzugt um weniger als 180° verschieden ist, auf. Insbesondere bevorzugt ist die erste Magnetfeldstärke stärker als die Koerzitivfeldstärke eines ersten magnetischen Materials, insbesondere bevorzugt stärker als 300kA/m Insbesondere bevorzugt ist die zweite Magnetfeldstärke geringer als die Koerzitivfeldstärke des ersten magnetischen Materials, insbesondere bevorzugt geringer als 100 kA/m, aber stärker als die Koerzitivfeldstärke eines zweiten magnetischen Materials, insbesondere bevorzugt stärker als 30 kA/m. In einer bevorzugten Ausführungsform fällt die Magnetfeldstärke des von dem Vormagnetisierungsmagneten erzeugten Magnetfelds entlang der Linie, die den ersten Ort und den zweiten Ort in der Ebene verbindet nach dem ersten Ort ab und übersteigt die erste Magnetfeldstärke nicht mehr bis zum zweiten Ort. Der Abfall der Magnetfeldstärke auf dem Weg zum zweiten Ort muss nicht stetig sein und muss nicht dauerhaft abfallend sein. Insbesondere bevorzugt übersteigt die Magnetfeldstärke die erste Magnetfeldstärke auch nicht mehr entlang einer Linie, die in Flucht zu der den ersten mit dem zweiten Ort verbindenden Linie über den zweiten Ort hinausgehend weist. Der Differenzwinkel beträgt insbesondere bevorzugt < 180°, ganz besonders bevorzugt < 145° und ist insbesondere bevorzugt in etwa 90°.

In einer besonders bevorzugten Ausführungsform ist die Vormagnetisiervorrichtung so aufgebaut, dass sich die Dipolmomente der einzelnen Magnetkomponenten in der Addition aufheben, so dass das Gesamtmagnetfeld ausschließlich Multipolmomente aufweist. Der besondere Vorteil besteht darin, dass sich bei einer solchen Anordnung das Magnetfeld mit wachsendem Abstand besonders schnell abschwächt, so dass bereits in geringem Abstand keine substanzielle magnetische Beeinflussung der Sensorzeile bzw. anderer Gerätekomponenten mehr möglich ist.

In einer bevorzugten Ausführungsform weist die Vormagnetisierungsvorrichtung zwei Vormagnetisierungsmagneten auf, die übereinander angeordnet sind und zwischen sich einen Spalt bilden, durch den ein Wertdokument geführt werden kann. Auch bei einer solchen Ausführungsform besteht der Vorteil, dass sich bei einer solchen Anordnung das gesamthaft von der Vormagnetisierungsvorrichtung erzeugte Vormagnetisierungsmagnetfeld mit wachsendem Abstand besonders schnell abschwächt, so dass bereits in geringem Abstand keine substanzielle magnetische Beeinflussung der Sensorzeile bzw. anderer Gerätekomponenten mehr möglich ist.

Bei der Messvorrichtung ist eine Sensorzeile mit mindestens einem sich in eine Zeilenrichtung erstreckenden magnetoresistiven Sensorelement vorgesehen, das magnetische Eigenschaften in seiner Umgebung messen kann. Das Sensorelement kann zum Messen der magnetischen Eigenschaften in seiner Umgebung insbesondere so ausgebildet sein, dass es den "anisotropen" magnetoresistiven Effekt (AMR-Effekt) oder den "gigantischen" magnetoresistiven Effekt (GMR-Effekt) aufweist. Das Sensorelement kann allerdings auch andere Effekte aufweisen, wie beispielsweise den Giant-Magneto-Impedance- (GMI), den Tunnel-Magneto-Resistance-Effekt (TMR) oder den Hall-Effekt.

Ein Sensorelement weist insbesondere bevorzugt vier oder mehrere zu einer Wheatstone-Brücke zusammen geschaltete einzelne Brückenwiderstände oder zwei oder mehrere zu einer halben Wheatstone'schen Brücke zusammen geschaltete einzelne Brückenwiderstände auf.

Das Sensorelement weist eine Breite und eine Länge sowie eine Höhe auf, wobei die Höhe geringer ist als die Breite und die Höhe geringer ist als die Länge und die Zeilenrichtung in Richtung der Breite oder in Richtung der Länge des Sensorelements weist.

In einer bevorzugten Ausführungsform weist das Sensorelement Widerstände auf, wobei der von den Widerständen gesamthaft eingenommene Raum eine Breite und eine Länge sowie eine Höhe aufweist, wobei die Höhe geringer ist als die Breite und die Höhe geringer ist als die Länge und die Zeilenrichtung in Richtung der Breite oder in Richtung der Länge des Sensorelements weist. Es ist denkbar, dass bei Sensorelementen mit Widerständen weitere Baugruppen als Teil des Sensorelements vorgesehen werden, wie beispielsweise elektrische Leitungen zum Anlegen einer Spannung an die Widerstände oder zum Messen einer Spannung. Diese Leitungen können in Richtung der Höhe abgeführt werden und dazu führen, dass das Sensorelement eine verhältnismäßig große Höhe erreicht, die beispielsweise auch der der Breite entsprechen kann. Bei solchen Bauformen ist es bevorzugt, dass zumindest der Raum, der von den Widerständen eingenommen wird die vorbeschriebene Auslegungsregel erfüllt.

Es kann auch vorgesehen sein, dass die Sensorelemente in Gruppen, d.h. zu mehreren in einer linienförmigen Anordnung bzw. linienförmigen Gruppe zum Ausbilden der Sensorzeile angeordnet sein können. Eine Anordnung bzw. Gruppe von Sensorelementen kann in einem Gehäuse angeordnet sein. Benachbarte Sensorelemente in einer Gruppe bzw. in einem Gehäuse weisen den gleichen Abstand auf. Die Gehäuse zur Ausbildung der Zeile können insbesondere so zueinander beabstandet sein, dass die benachbarten Sensorelemente von zueinander benachbarten Gehäusen bzw. Gruppen zum Aufbau einer Zeile den gleichen Abstand aufweisen wie der Abstand der Sensorelemente in einem Gehäuse zueinander.

Die Vorteile der Erfindung können bereits mit einem sich in eine Zeilenrichtung erstreckenden magnetoresistiven Sensorelement erreicht werden. Dabei wird bei einem sich in eine Zeilenrichtung erstreckenden, vier oder mehrere zu einer Wheatstone'schen Brücke zusammengeschalteten einzelne Brückenwiderstände aufweisenden Sensorelement das Erstrecken in eine Zeilenrichtung derart verstanden, dass zumindest zwei dieser Einzelwiderstände in Zeilenrichtung nebeneinander angeordnet sind. Besonders bevorzugt weist die Sensorzeile jedoch mindestens zwei magnetoresistive Sensorelemente auf, die in Zeilenrichtung hintereinander angeordnet sind. Die Länge der Sensorzeile und damit die Zahl der verwendeten magnetoresistiven Sensorelemente hängt von der durchzuführenden Messung ab. Zur Messung von Euro-Banknoten kann eine Sensorzeile beispielsweise mehr als 5, mehr als 8, mehr als 10, insbesondere bevorzugt mehr als 20, beispielsweise mehr als 31 und bevorzugt 90 Sensorelemente aufweisen.

Zur Bildung der Sensorzeile sind - soweit vorhanden - die Sensorelemente in einer Zeile angeordnet. Insbesondere bevorzugt liegen die Sensorelemente auf einer Linie. Es ist aber auch denkbar, dass die Sensorelemente einer einzelnen Zeile bezogen auf eine in Zeilenrichtung weisende Achse unterschiedlich angeordnet sind, sodass die Längsmittelachsen der Einzelsensoren nicht mehr alle auf einer Linie liegen. Insbesondere bevorzugt sind derart angeordnete Sensorelemente jedoch so angeordnet, dass sie sich in Richtung der Zeilenrichtung gesehen teilweise überlappen.

In einer bevorzugten Ausführungsform sind mehrere Sensorelemente zu einer Baugruppe zusammengefasst, beispielsweise auf einer gemeinsamen Trägerstruktur angeordnet. Eine solche Baugruppe wird nachfolgend als Sensor bezeichnet. Ein Sensor kann beispielsweise zwei, drei, vier oder mehr Sensorelemente aufweisen. Es ist aber auch möglich, dass ein Sensor durch ein einziges Sensorelement gebildet wird.

Die Messvorrichtung ist zum Messen magnetischer Eigenschaften der Umgebung der Messvorrichtung geeignet. Unter magnetischen Eigenschaften der Umgebung der Messvorrichtung werden insbesondere die Magnetfeldstärke eines magnetischen Feldes in der Umgebung der Messvorrichtung, die Feldrichtung eines magnetischen Feldes in der Umgebung der Messvorrichtung oder aber auch beispielsweise die Änderung der Feldstärke, bzw. Feldrichtung eines magnetischen Feldes in der Umgebung der Messvorrichtung verstanden. Beispielsweise wird als magnetische Eigenschaft der Umgebung die Änderung der Feldstärke und der Feldrichtung des die Messvorrichtung umgebenden magnetischen Feldes verstanden, wenn sich dieses Feld durch Überlagerung eines Feldes ändert, das von einem magnetischen Muster einer Banknote erzeugt wird. In einer bevorzugten Ausführungsform wird die Sensorzeile so ausgelegt, dass sie nur räumliche und/oder zeitliche Änderungen der magnetischen Eigenschaften der Umgebung der Messvorrichtung detektiert.

In einer bevorzugten Ausführungsform ist das Sensorelement derart ausgebildet, dass es magnetische Eigenschaften der Umgebung der Messvorrichtung, wozu definitionsgemäß auch die Änderung einer Feldstärke gehört, nur in einer als Messrichtung bezeichneten Richtung eines orthogonalen Koordinatensystems messen kann, bzw. in einer alternativen Ausführungsform nur in zwei Richtungen eines orthogonalen Koordinatensystems messen kann, die in einer als Sensormessebene bezeichneten Ebene liegen.

In einer bevorzugten Ausführungsform ist die Messvorrichtung zum Messen magnetischer Strukturen eines Scheins oder eines Bogens, insbesondere eines Geldscheins oder Schecks, ausgebildet und weist geeignete Mittel auf, um den Schein oder den Bogen zumindest in einem der Sensorzeile benachbarten Bereich in einer Messebene an der Sensorzeile vorbei zu bewegen. Dabei wird die Richtung, in die der Schein, bzw. der Bogen bewegt wird, als Leserichtung bezeichnet. Insbesondere bevorzugt ist das Sensorelement derart ausgebildet, dass die Messrichtung der Leserichtung entspricht, das Sensorelement also nur magnetische Eigenschaften seiner Umgebung in Leserichtung messen kann.

In einer bevorzugten Ausführungsform werden eine Stützfeldvorrichtung sowie der, bzw. mehrere Vormagnetisierungsmagnete eingesetzt. Diese können aus einem oder mehreren Bauteilen, beispielsweise Permanentmagneten bestehen. Insbesondere bevorzugt wird die Stützfeldvorrichtung durch einen Einzelmagneten mit lokal variierender Magnetisierungsverteilung gebildet, insbesondere bevorzugt durch einen Polstreifen. In einer bevorzugten Ausführungsform weisen die Stützfeldvorrichtung und/oder der Vormagnetisierungsmagnet Permanentmagneten auf. Der Vormagnetisierungsmagnet und/oder die Stützfeldvorrichtung können jedoch auch elektrische Spulen aufweisen, die das gewünschte Magnetfeld erzeugen.

In einer bevorzugten Ausführungsform sind die Sensorelemente in Zeilenrichtung äquidistant angeordnet. In einer besonders bevorzugten Ausführungsform beträgt der Abstand eines ersten Sensorelements zu einem benachbarten Sensorelement, bezogen auf den Abstand zwischen den Mittelpunkten der beiden Sensorelemente, zwischen 1 und 10 mm, vorzugsweise zwischen 2 und 5 mm und insbesondere bevorzugt 3,5 mm. In einer besonders bevorzugten Ausführungsform weist ein Chip zwei in Zeilenrichtung nach einander angeordnete Sensorelemente auf und weist - ohne Gehäuse - eine Länge von 1 ,5 bis 9 mm, vorzugsweise von 2 bis 3 mm und insbesondere bevorzugt von 2,5 mm in Zeilenrichtung auf. In einer bevorzugten Ausführungsform beträgt der Abstand von einem Rand eines Chips zu dem Rand des benachbarten Chips weniger als 1 ,5 mm und insbesondere bevorzugt weniger als 1 ,1 mm.

In einer alternativen Ausführungsform sind die Sensorelemente derart angeordnet, dass der Abstand zwischen zwei Rändern zweier benachbarter Sensorelemente, die auf einem Chip angeordnet sind, kleiner ist, als der Abstand zwischen zwei Rändern benachbarter Sensorelemente, die nicht auf einem Chip angeordnet sind. Der Abstand zwischen zwei Chips ist in der Regel durch die Technologie vorgegeben, mit der ein Chip auf einer Trägerplatte verbunden werden kann. Diese Technologien benötigen in der Regel mehr Raum als der Raum, der benötigt wird, um zwei magnetoresistive Sensorelemente auf einem Chip anzuordnen. Die Empfindlichkeit der Messvorrichtung kann deshalb dadurch gesteigert werden, dass sowohl die Anbringung der Sensorelemente auf dem Chip als auch die Anbringung der Chips auf dem Board so dicht wie nach der jeweils eingesetzten Technologie möglich erfolgt.

Die Herstellung der Sensorelemente auf den Chips erfolgt bevorzugt mit den Methoden der Planartechnik, Halbleitertechnik oder Mikrosystemtechnik.

Die Stützfeldvorrichtung kann insbesondere aus plastikgebundenem Hartferrit oder Seltenerdmagneten, die gespritzt oder gepresst wurden oder aus gesinterten Seltenerdmagneten oder anderen Permanentmagnetwerkstoffen hergestellt werden. Die Stützfeldvorrichtung kann eine Anordnung permanentmagnetischer Magnete aufweisen, die im unmagnetischen Zustand auf einer Trägerplatte aufgebracht und erst danach gemeinsam magnetisiert werden.

In einer bevorzugten Ausführungsform ist eine Stützfeldvorrichtung mit einer Zeile nebeneinander angeordneten Magneten, bei denen die Magnetisierung alterniert, im Verhältnis zur Sensorzeile so angeordnet, dass der Übergang von einem Magneten zum benachbarten Magneten in der Mitte zumindest eines Sensorelements, bezogen auf seine Ausdehnung in Zeilenrichtung angeordnet ist. Dadurch wird auf einfache Weise erreicht, dass der Feldstärkenverlauf in Zeilenrichtung an nacheinander angeordneten Sensorrändern der die Sensorzeile bildenden Sensorelemente keinen Nulldurchgang und/oder kein Maximum oder Minimum aufweist.

In einer besonders bevorzugten Ausführungsform ist die Messvorrichtung dazu ausgebildet, magnetische Strukturen eines Scheins oder eines Bogens, insbesondere eines Geldscheins zu erkennen, und weist geeignete Mittel auf, um den Schein oder Bogen zumindest in einem der Sensorzeile benachbarten Bereich in einer Messebene an der Sensorzeile vorbei zu bewegen. Die Messebene ist die Ebene, in der sich der Schein oder der Bogen befindet, wenn er untersucht wird. Demgegenüber wird als Sensormessebene die Ebene verstanden, in der ein entsprechend ausgeführtes magnetoresistives Sensorelement die Eigenschaften seiner Umgebung messen kann. Die Sensormessebene ist die Ebene, in der die für die Messungen wirksamen Elemente des Sensorelements liegen und die dort die Eigenschaften des auf sie einwirkenden Magnetfeldes messen. Die Messebene ist beabstandet zu der Sensormessebene. Das Bewegen des zu untersuchenden Messobjekts durch die Messebene bewirkt jedoch auch eine Veränderung des auf die Sensorelemente in der Sensormessebene einwirkenden Magnetfeldes. Das Beobachten der Änderung der Eigenschaften des in der Sensormessebene auf das Sensorelement wirkenden Magnetfeldes erlaubt somit Rückschlüsse auf Gegebenheiten, beispielsweise den Hindurchtritt von magnetischem bzw. magnetisierbarem Material durch die Messebene.

Für das Bewegen des Scheins oder Bogens geeignete Mittel sind insbesondere Walzen, die einen Walzspalt zwischen sich bilden, in der der Schein oder der Bogen gehalten werden kann. Werden zwei Gruppen solcher Walzen verwendet und die zwischen den Walzen der jeweiligen Gruppe gebildeten Walzspalte entsprechend zueinander ausgerichtet, so kann ein Schein oder ein Bogen zwischen den beiden Walzengruppen in einer Ebene an der Sensorzeile vorbei bewegt werden. Ebenso kann der Schein oder Bogen auf einem Transportband, beispielsweise einem eine Gummioberfläche aufweisenden Transportband oder einem aus einem Fließ bestehenden Transportband liegend an der Sensorzeile vorbei bewegt werden.

In einer bevorzugten Ausführungsform weist die Messvorrichtung Mittel auf, um den Schein oder den Bogen zumindest in einem der Sensorzeile benachbarten Bereich in einer Messebene an der Sensorzeile vorbei zu bewegen. In dieser bevorzugten Ausführungsform sind die das von ihm erzeugte magnetische Feld beeinflussenden Eigenschaften des Vormagnetisierungsmagneten und seine Anordnung relativ zur Sensorzeile derart gewählt, dass die Feldstärke des durch den Vormagnetisierungsmagneten erzeugten magnetischen Feldes in allen Richtungen eines orthogonalen Koordinatensystems am Ort der Messebene größer ist, als an einer Stelle der Sensorzeile. Bei den Ausführungsformen, bei denen ein Sensorelement verwendet wird, das im Wesentlichen nur in einer als Sensormessebene bezeichneten Ebene die magnetischen Eigenschaften seiner Umgebung messen kann, ist in dieser bevorzugten Ausführungsform die Feldstärke des durch den Vormagnetisierungsmagneten erzeugten magnetischen Feldes in allen Richtungen eines orthogonalen Koordinatensystems am Ort der Messebene größer als an einem Ort der Sensormessebene.

In einer bevorzugten Ausführungsform sind die Sensorzeile, die Vormagnetisierungsvorrichtung und die Stützfeldvorrichtung in einem Gehäuse integriert. Insbesondere bevorzugt werden die Sensorzeile, die Vormagnetisierungsvorrichtung und die Stützfeldvorrichtung auf einer Leiterplatte integriert. Vormagnetisierungsvorrichtung und/oder Stützfeldvorrichtung können aber auch Bestandteil des Gehäuses sein. In einer bevorzugten Ausführungsform weist das Gehäuse eine Vorrichtung zur Fixierung eines Schutzbleches auf, das Sensorzeile und/oder Vormagnetisierungsvorrichtung vor Abrieb schützt.

In einer alternativen Ausführungsform sind die Sensorzeile und eine etwaig vorgesehene Stützfeldvorrichtung zu einer Baugruppe zusammengefasst, insbesondere bevorzugt in einem Gehäuse zusammengefasst, während die Vormagnetisierungsvorrichtung als separate Baugruppe ausgeführt ist, insbesondere bevorzugt in einem eigenen Gehäuse angeordnet ist. Es hat sich gezeigt, dass die Erkenntnis der Erfindung auch dazu genutzt werden kann, bestehende Messvorrichtungen zum Messen magnetischer Eigenschaften der Umgebung der Messvorrichtung nachzurüsten. Diese bestehenden Messvorrichtungen weisen in der Regel eine Sensorzeile und ggf. eine Stützfeldvorrichtung auf, die zu einer Baugruppe zusammengefasst sind, beispielsweise durch Anordnung in einem Gehäuse. Die Vorteile der Erfindung können bei solchen bestehenden Messvorrichtung auch dadurch erreicht werden, dass der bestehenden Baugruppe der Vormagnetisierungsmagnet als eigenständige Baugruppe vorgeschaltet wird. Beispielsweise kann ein bestehender Geldautomat dadurch nachgerüstet werden, dass ohne Änderung der Baugruppe mit der Sensorzeile und der ggf. vorhandenen Stützfeldvorrichtung der Vormagnetisierungsmagnet in diesem Geldautomaten verbaut wird. Es ist in einer solchen Ausführungsform sogar denkbar, dass die bestehende Baugruppe mit der Sensorzeile und der ggf. vorhandenen Stützfeldvorrichtung bereits einen eigenen Vormagnetisierungsmagneten aufweist, der ein erfindungsgemäß verwendeter Vormagnetisierungsmagnet sein kann, aber in der Regel nicht ist. In einem solchen Ausführungsbeispiel kann der als separate Baugruppe in den Transportweg vorgeschaltete Vormagnetisierungsmagnet den Geldschein geeignet (d.h. einheitlich) vormagnetisieren, und das durch den Baugruppen-eigenen Vormagnetisierungsmagneten erzeugte Magnetfeld könnte die Magnetisierung der unterschiedlichen Materialien so ummagnetisieren, dass die unterschiedlichen Materialien im bestehenden Magnetfeldsensor unterscheidbar sind.

In einer bevorzugten Ausführungsform ist die Sensorzeile durch ein Gehäuse umschlossen. Insbesondere bevorzugt ist die Sensorzeile durch ein Gehäuse umschlossen, dessen Fläche, die Kontakt zum Messobjekt hat, einen möglichst kleinen Abstand zum Messobjekt zulässt und abriebfest gestaltet ist. In einer bevorzugten Ausführungsform ist die Sensorzeile durch ein Gehäuse umschlossen ist, dessen Wände, außer der Wand, die Kontakt zum Messobjekt hat, eine magnetische Abschirmung darstellen. In einer bevorzugten Ausführungsform ist die Stützfeldvorrichtung im Sensorgehäuse integriert.

In einer bevorzugten Ausführungsform ist die Sensorzeile durch ein Stecker kontaktierbar.

In einer bevorzugten Ausführungsform ist ein Teil der Stützfeldvorrichtung als Element auf dem einzelnen Brückenwiderstand ausgebildet.

In einer bevorzugten Ausführungsform weist der Vormagnetisierungsmagnet eine Höhe, eine Breite und eine Länge aufweist, wobei die Länge größer ist als die Höhe und größer ist als die Breite und wobei die Längserstreckung des Vormagnetisierungsmagneten parallel zur Zeilenrichtung ausgerichtet ist.

In einer bevorzugten Ausführungsform weist die Messvorrichtung einen ersten Vormagnetisierungsmagneten und einen zweiten Vormagnetisierungsmagneten auf, wobei der zweite Vormagnetisierungsmagnet in einer senkrecht zur Längserstreckung des ersten Vormagnetisierungsmagneten und senkrecht zur Zeilenrichtung weisenden Durchlaufrichtung vom ersten Vormagnetisierungsmagneten aus hinter der Sensorzeile angeordnet ist. Dadurch kann die Messvorrichtung dazu eingesetzt werden, Messobjekte zu messen, die entweder von der einen oder von der anderen Seite an die Sensorzeile herangeführt werden.

In einer bevorzugten Ausführungsform weist das Sensorelement eine Breite und eine Länge sowie eine Höhe auf, wobei die Höhe geringer ist als die Breite und die Höhe geringer ist als die Länge und die Zeilenrichtung in Richtung der Breite oder in Richtung der Länge des Sensorelements weist. Die einen Vormagnetisierungsmagneten aufweisende Vormagnetisierungsvorrichtung und eine von der Vormagnetisierungsvorrichtung unterschiedliche Stützfeldvorrichtung, die in dem Bereich, über den sich die Sensorzeile erstreckt, ein magnetisches Stützfeld erzeugt, sind so angeordnet, dass der Vormagnetisierungsmagnet in einer zur Zeilenrichtung senkrechten Richtung von der Sensorzeile beabstandet angeordnet ist und sich in einer Richtung parallel zur Zeilenrichtung erstreckt, wobei
- das magnetoresistive Sensorelement im Wesentlichen nur in einer als Messrichtung bezeichneten Richtung eines orthogonalen Koordinatensystems oder im Wesentlichen nur in einer als Sensormessebene bezeichneten, durch zwei senkrechte Messrichtungen eines orthogonalen Koordinatensystems aufgespannten Ebene die magnetischen Eigenschaften seiner Umgebung messen kann,
- bei einer nur aus einem Vormagnetisierungsmagneten bestehenden Vormagnetisierungsvorrichtung die das von ihm erzeugte magnetische Feld beeinflussenden Eigenschaften des Vormagnetisierungsmagneten und seine Anordnung relativ zur Sensorzeile sowie das von der Stützfeldvorrichtung erzeugte Stützfeld derart gewählt sind, dass ein Überlagerungsmagnetfeld aus der Überlagerung des von der Vormagnetisierungsvorrichtung erzeugten Magnetfelds und des Stützfelds entsteht, dessen Stärke der in Zeilenrichtung weisenden Feldkomponente zumindest an einem Ort auf der Sensorzeile größer ist als die Stärke der senkrecht zur Zeilenrichtung und nicht in Richtung der Höhe des Sensorelements weisenden Feldkomponente, oder
- bei einer aus mehreren Vormagnetisierungsmagneten bestehenden Vormagnetisierungsvorrichtung die das von ihnen erzeugte magnetische Feld beeinflussenden Eigenschaften der Vormagnetisierungsmagneten und die Anordnung der Vormagnetisierungsmagneten relativ zur Sensorzeile sowie das von der Stützfeldvorrichtung erzeugte Stützfeld derart gewählt sind, dass ein Überlagerungsmagnetfeld aus der Überlagerung des von der Vormagnetisierungsvorrichtung erzeugten Magnetfelds und des Stützfelds entsteht, dessen Stärke der in Zeilenrichtung weisenden Feldkomponente zumindest an einem Ort auf der Sensorzeile größer ist als die Stärke der senkrecht zur Zeilenrichtung und nicht in Richtung der Höhe des Sensorelements weisenden Feldkomponente.

Bei dieser Ausführungsform werden ein oder mehrere die Sensorzeile bildende magnetoresistive Sensorelemente eingesetzt, die im wesentlichen nur in einer als Messrichtung bezeichneten Richtung eines orthogonalen Koordinatensystems oder in einer als Sensormessebene bezeichneten, durch zwei senkrechte Messrichtungen eines orthogonalen Koordinatensystems aufgespannte Ebenen die magnetischen Eigenschaften seiner Umgebung messen können. Als Chip ausgeführte Sensorelemente, die auf einem magnetoresistiven Effekt beruhen, können so ausgeführt werden, dass sie die magnetischen Feldkomponenten in einer Messrichtung in der Chipebene detektiert. Derart als Chip ausgeführte Sensorelemente, die auf einem magnetoresistiven Effekt beruhen, können also nur bzw. im Wesentlichen feststellen, ob sich die Feldstärke einer einzigen in der Chipebene liegenden Feldkomponente des auf das Sensorelement einwirkenden Magnetfelds ändert. Dies kann beispielsweise durch ein sog. Barberpole Design erreicht werden, wie es beispielsweise in Dibbern, U. (2008) Magnetoresistive Sensors, in Sensors Set: A Comprehensive Survey (eds W. Göpel, J. Hesse and J. N. Zemel), Wiley-VCH Verlag GmbH, Weinheim, Germany beschrieben ist. Werden mehrere dieser Sensorelemente in einer Zeilenrichtung angeordnet, so können die Sensorelemente so ausgeführt werden, dass die Messrichtung senkrecht zur Zeilenrichtung ausgerichtet ist. Magnetoresistive Sensoren, die in planaren Dünnschichttechnologie gefertigt sind, sind nahezu unempfindlich auf die Feldkomponente senkrecht zur Chipebene, insbesondere auf Änderungen der Feldstärke der Feldkomponente senkrecht zur Chipebene des auf dem Chip einwirkenden Magnetfelds.

Das Überlagerungsmagnetfeld wird als das auf die Sensorzeile wirkende Feld verstanden, wenn noch keine zu messenden, die magnetischen Eigenschaften der Umgebung der Sensorzeile bewirkenden Maßnahmen, wie beispielsweise das Vorbeiführen eines Geldscheins an der Sensorzeile vorbei, erfolgt sind. Das Überlagerungsmagnetfeld ist demnach das dauerhaft auf die Sensorzeile wirkende, aus der Überlagerung von dem von der Vormagnetisierungsvorrichtung erzeugten Vormagnetisierungsmagnetfeld und dem von der Stützfeldvorrichtung erzeugten Stützfeld entstehende Magnetfeld. Das Überlagerungsmagnetfeld ist in einer bevorzugten Ausführungsform zeitlich invariant.

Die in der bevorzugten Ausführungsform vorgeschlagene Wahl des Überlagerungsmagnetfelds bewirkt, dass das Vormagnetisierungsmagnetfeld den Einfluss des Stützfelds auf die Sensorzeile nicht nachteilig beeinflusst.

Gemäß der bevorzugten Ausführungsform wird beansprucht, dass ein Überlagerungsmagnetfeld erzeugt wird, dessen Stärke der in Zeilenrichtung weisenden Feldkomponente zumindest an einem Ort auf der Sensorzeile größer ist als die Stärke der senkrecht zur Zeilenrichtung und nicht in Richtung der Höhe des Sensorelements weisenden Feldkomponente. Dabei wird unter dem Begriff "Stärke" insbesondere der Betrag der Feldkomponente verstanden, unabhängig davon, ob die Feldkomponente an diesem Ort in die positive Richtung der Feldkomponente oder in die negative Richtung der Feldkomponente weist.

Es kann sowohl im Falle eines Vormagnetisierungsmagneten als auch im Falle mehrerer Vormagnetisierungsmagneten insbesondere vorgesehen sein, dass die Stärke der Feldkomponente des aus der Überlagerung des von der Überlagerungsmagnetfelds (aus Überlagerung des von Vormagnetisierungsvorrichtung erzeugten Magnetfelds und des Stützfelds entstehend) in Zeilenrichtung zumindest an einem Ort auf der Sensorzeile kleiner ist als die Stärke der in Richtung der Höhe des Sensorelements weisenden Feldkomponente. Es kann sich somit ergeben, dass die Vormagnetisierungsvorrichtung die das von ihm erzeugte magnetische Feld beeinflussenden Eigenschaften des Vormagnetisierungsmagneten bzw. der Vormagnetisierungsmagneten und seine bzw. ihre Anordnung relativ zur Sensorzeile sowie das von der Stützfeldvorrichtung erzeugte Stützfeld derart gewählt sind, dass ein Überlagerungsmagnetfeld aus der Überlagerung des von der Vormagnetisierungsvorrichtung erzeugten Magnetfelds und des Stützfelds entsteht, dessen Stärke der in Zeilenrichtung weisenden Feldkomponente zumindest an einem Ort auf der Sensorzeile größer ist als die Stärke der senkrecht zur Zeilenrichtung wirkenden Feldkomponente, die nicht in Richtung der Höhe des Sensorelements weist, und die Stärke der in Zeilenrichtung weisenden Feldkomponente zumindest an einem Ort auf der Sensorzeile kleiner ist als die Stärke der in Richtung der Höhe des Sensorelements weisenden Feldkomponente. Insbesondere kann es vorgesehen sein, dass die Vormagnetisierungsvorrichtung und die Stützfeldvorrichtung räumlich voneinander getrennt angeordnet sind.

Es kann ermöglicht werden, die Feldkomponenten funktional zu "trennen". In Zeilenrichtung kann das Stützfeld für die Sensorelemente ausgerichtet sein. In Bewegungsrichtung des zu messenden Objekts (beispielsweise Geldschein oder Bogen), d.h. senkrecht zur Zeilenrichtung, aber nicht in Richtung der Erstreckung der Höhe der Sensorelemente, kann das Messfeld ausgerichtet sein. In Höhe der Sensorelemente kann die Vormagnetisierung ausgerichtet sein. Bevorzugt ist dabei die Feldkomponente in Zeilenrichtung klein, wobei die Feldkomponente in Bewegungsrichtung ohne Objekt möglichst Null sein kann und bei Vorhandensein eines Objekts vom Objekt abhängig ist, und insbesondere bevorzugt die Feldkomponente in Richtung der Höhe des Sensorelements sehr groß gewählt ist.

In einer bevorzugten Ausführungsform ist das, bzw. sind die die Sensorzeile bildenden Sensorelemente derart angeordnet und ausgebildet, dass sie im Wesentlichen nur in Zeilenrichtung die magnetischen Eigenschaften der Umgebung messen können, bzw. bei Sensorelementen, die im Wesentlichen nur in einer als Sensormessebene bezeichneten, durch zwei senkrechte Messrichtungen eines orthogonalen Koordinatensystems aufgespannten Ebene die magnetischen Eigenschaften seiner Umgebung messen können, die Zeilenrichtung eine dieser Messrichtungen ist.

In einer alternativen, ebenfalls bevorzugten Ausführungsform ist das bzw. sind die die Sensorzeile bildenden Sensorelemente derart angeordnet und ausgebildet, dass sie im Wesentlichen nur in eine Richtung senkrecht zur Zeilenrichtung die magnetischen Eigenschaften der Umgebung messen können. Wie vorstehend ausgeführt, ist es möglich, mehrere als Chip ausgeführte Sensorelemente, die auf einem magnetoresistiven Effekt beruhen, in einer Zeilenrichtung anzuordnen, sodass die Sensorelemente so ausgeführt werden, dass die empfindliche Messrichtung senkrecht zur Zeilenrichtung (und dabei nicht in Richtung der Höhe des Sensorelements) ausgerichtet ist.

In einer bevorzugten Ausführungsform ist auf mindestens 50% der Orte, insbesondere bevorzugt an mindestens 60% und insbesondere bevorzugt an mindestens 70% der Orte der Sensorzeile die Stärke der in Zeilenrichtung weisenden Feldkomponente des Überlagerungsmagnetfelds größer als die Stärke der senkrecht zur Zeilenrichtung und nicht in Richtung der Höhe des Sensorelements weisenden Feldkomponente des Überlagerungsmagnetfelds.

In einer bevorzugten Ausführungsform ist an den genannten Orten die Stärke der in Zeilenrichtung weisenden Feldkomponente des Überlagerungsmagnetfelds um das 10fache, insbesondere bevorzugt um das 100fache kleiner als die Stärke der senkrecht zur Zeilenrichtung und in Richtung der Höhe des Sensorelements weisende Feldkomponente des Überlagerungsmagnetfelds.

Bei einer derartigen Auslegung der Vormagnetisierungsvorrichtung kann der Vorteil erreicht werden, dass das von der Stützfeldvorrichtung erzeugte Stützfeld in der Messrichtung, bzw. in der Sensormessebene, auf die das Messen der magnetischen Eigenschaften durch das Sensorelement beschränkt ist, ungestört von einer Überlagerung eines weiteren magnetischen Feldes durch die Vormagnetisierungsvorrichtung erzeugt werden kann. Dieser Aspekt der Erfindung birgt insbesondere den Vorteil, dass durch den Vormagnetisierungsmagnet die gewünschte Magnetisierung des Objekts, das die magnetischen Eigenschaften der Umgebung der Messvorrichtung beeinflussen soll, um diese durch die Messvorrichtung messen zu lassen, erfolgen kann, ohne die Messeigenschaften des Sensorelements signifikant zu beeinflussen.

Die so weitergebildete Messvorrichtung bietet den Vorteil, dass die zur Vormagnetisierung der hartmagnetischen Materialien notwendigen Maßnahmen und die für das Erkennen weichmagnetischer Materialien notwendigen Maßnahmen von der für den Sensorbetrieb notwendigen Stützfeldverteilung getrennt werden können. Der Vormagnetisierungsmagnet kann als erste magnetische Funktionsgruppe zumindest die hartmagnetischen Materialien und - soweit gewünscht - die weichmagnetischen Materialien während deren Messung magnetisieren. Die Stützfeldvorrichtung als zweite magnetische Funktionsgruppe kann eine Verteilung der in Zeilenrichtung weisenden Stützfeld-Magnetfeldkomponente liefern, die einen möglichst empfindlichen und lückenlosen Nachweis magnetischer Sicherheitsmerkmale ermöglicht.

Die so weitergebildete Messvorrichtung bietet den weiteren Vorteil, dass die Stützfeldvorrichtung so ausgelegt, insbesondere bevorzugt mit einem oder mehreren so kleinen Stützfeldmagneten ausgeführt werden kann, dass die Stützfeldvorrichtung lediglich die Funktion erfüllt, eine Verteilung der in Zeilenrichtung weisenden Stützfeld-Magnetfeldkomponente zu liefern, die einen möglichst empfindlichen und lückenlosen Nachweis magnetischer Sicherheitsmerkmale ermöglicht. Es wurden Versuche unternommen, die Stützfeldvorrichtung derart auszulegen, dass das von ihr erzeugte Stützfeld auch in der Lage war, weichmagnetische Materialien während der Messung zu magnetisieren. Hierfür ist es notwendig, eine Stützfeldvorrichtung mit mindestens einem Stützfeldmagneten zu verwenden, bei dem das von ihm erzeugte Magnetfeld nicht nur im Bereich der Sensorelemente, sondern auch in dem Bereich eine Wirkung entfaltet, in dem sich das zu untersuchende Messobjekt befindet, bzw. durch den das zu untersuchende Messobjekt bewegt wird. Insbesondere musste ein Stützfeldmagnet eingesetzt werden, dessen Magnetfeld in dem Bereich, in dem sich das zu untersuchende Messobjekt befindet, bzw. durch den das zu untersuchende Messobjekt bewegt wird, eine Wirkung entfaltet, die ausreicht, um weichmagnetische Materialien während der Messung zu magnetisieren. Es hat sich gezeigt, dass hierfür relativ große Stützfeldmagneten eingesetzt werden müssen. Da es die Messvorrichtung nun erlaubt, die Stützfeldvorrichtung so auszulegen, dass sie allein die Funktion erfüllt, eine Verteilung der in Zeilenrichtung weisenden Stützfeld-Magnetfeldkomponente zu liefern, die einen möglichst empfindlichen und lückenlosen Nachweis magnetischer Sicherheitsmerkmale ermöglicht, kann die Stützfeldvorrichtung besonders kompakt ausgebildet werden.

In einer besonders bevorzugten Ausführungsform werden die zunächst unmagnetisierten Stützfeldmagnete in einem gemeinsamen Arbeitsgang mit den Sensoren auf einer Trägerplatte aufgelötet. Bevorzugt werden die Stützfeldmagnete nach dem Auflöten magnetisiert.

In einer bevorzugten Ausführungsform bei einer aus einem Vormagnetisierungsmagneten bestehenden Vormagnetisierungsvorrichtung sind die das von ihm erzeugte magnetische Feld beeinflussenden Eigenschaften des Vormagnetisierungsmagneten und seine Anordnung relativ zur Sensorzeile derart gewählt, dass an keiner Stelle eines Sensorelements der Sensorzeile die Feldstärke des durch den Vormagnetisierungsmagneten erzeugten magnetischen Felds in keiner der drei Richtungen, zumindest aber insbesondere in keiner von zwei Richtungen eines orthogonalen Koordinatensystems stärker ist als die Feldstärke des durch die Stützfeldvorrichtung erzeugten Magnetfelds in der jeweils entsprechenden Richtung des orthogonalen Koordinatensystems, sofern die Zeilenrichtung betrachtet wird. In einer bevorzugten Ausführungsform bei einer aus mehreren Vormagnetisierungsmagneten bestehenden Vormagnetisierungsvorrichtung sind die das von ihnen erzeugte magnetische Feld beeinflussenden Eigenschaften der Vormagnetisierungsmagneten und die Anordnung der Vormagnetisierungsmagneten relativ zur Sensorzeile derart gewählt sind, dass an keiner Stelle eines Sensorelements der Sensorzeile die Feldstärke des durch die Überlagerung der von den Vormagnetisierungsmagneten jeweils einzeln erzeugten magnetischen Felder erzeugten magnetischen Feldes in keiner der drei Richtungen, zumindest aber insbesondere in keiner von zwei Richtungen eines orthogonalen Koordinatensystems stärker ist als die Feldstärke des durch die Stützfeldvorrichtung erzeugten Magnetfeldes in der Messrichtung, sofern die Zeilenrichtung betrachtet wird.

Das erfindungsgemäße Verfahren nach Anspruch 1 zur Vormagnetisierung magnetischer Materialien auf einem Messobjekt mit einem ersten magnetischen Material mit einer ersten Koerzitivfeldstärke und einem zweiten magnetischen Material mit einer zweiten Koerzitivfeldstärke, die niedriger ist als die erste Koerzitivfeldstärke, sieht vor, dass das Messobjekt von einem ersten Punkt zu einem zweiten Punkt und dann zu einem dritten Punkt durch ein Vormagnetisierungsfeld eines Vormagnetisierungsmagnets geführt wird, wobei
- die Feldstärke des Vormagnetisierungsfelds am ersten Punkt größer ist als die erste und größer ist als die zweite Koerzitivfeldstärke,
- die Feldstärke des Vormagnetisierungsfelds am zweiten Punkt größer ist als die zweite Koerzitivfeldstärke und nach Verlassen des zweiten Punkts unter die erste Koerzitivfeldstärke fällt und während der Bewegung des Messobjekts vom zweiten zum dritten Punkt nicht mehr über die erste Koerzitivfeldstärke steigt und die Feldrichtung des Vormagnetisierungsfelds am zweiten Punkt in eine erste Richtung weist und
- die Feldstärke des Vormagnetisierungsfelds beim Erreichen des dritten Punkts unter die zweite Koerzitivfeldstärke fällt und während der Bewegung des Messobjekts vom dritten zur Sensorzeile nicht mehr über die zweite Koerzitivfeldstärke steigt und die Feldrichtung des Vormagnetisierungsfelds am dritten Punkt in eine zweite Richtung weist, die unterschiedlicher zur ersten Richtung ist. Insbesondere bevorzugt weist die zweite Richtung nicht im Winkel von 180° zur ersten Richtung.

Insbesondere bevorzugt wird die Messvorrichtung für das Prüfen von Scheinen oder Bögen, insbesondere von Geldscheinen, Schecks oder anderen Papierbögen auf das Vorhandensein magnetischer Merkmale verwendet, insbesondere daraufhin, ob die Scheine oder Bögen besondere, vorher festgelegte magnetische Merkmale aufweisen. Ein weiteres mögliches Anwendungsgebiet ist die Prüfung ferromagnetischer oder bewegter, elektrisch leitfähiger Objekte auf Unregelmäßigkeiten oder Materialfehler.

Nachfolgend wird die Erfindung anhand von lediglich Ausführungsbeispiele der Erfindung darstellenden Zeichnungen näher erläutert. Darin zeigen:
Fig. 1: eine perspektivische Ansicht einer Messvorrichtung zum Messen magnetischer Eigenschaften der Umgebung der Messvorrichtung in einer schematischen Darstellung gemäß einer ersten Ausführungsform;
Fig. 2: eine perspektivische Ansicht einer Messvorrichtung zum Messen magnetischer Eigenschaften der Umgebung der Messvorrichtung in einer schematischen Darstellung gemäß einer zweiten Ausführungsform;
Fig. 3: eine perspektivische Ansicht des prinzipiellen Aufbaus eines Sensorelements der Messvorrichtung;
Fig. 4: eine schematische Seitenansicht einer nicht zur Erfindung gehörenden Messvorrichtung zum Messen magnetischer Eigenschaften der Umgebung der Messvorrichtung mit zwei Vormagnetisierungsmagneten mit homogener Magnetisierung, in der die Feldlinien des von den Vormagnetisierungs-magneten erzeugten magnetischen Felds eingezeichnet sind;
Fig. 5: eine schematische Seitenansicht einer Ausführungsform der Messvorrichtung zum Messen magnetischer Eigenschaften der Umgebung der Messvorrichtung mit zwei Vormagnetisierungsmagneten mit nichthomogener Magnetisierung, in der die Feldlinien des von den Vormagnetisierungsmagneten erzeugten magnetischen Felds eingezeichnet sind;
Fig. 6: eine Graphik, die den Verlauf des Betrags der Feldstärke des von den Vormagnetisierungsmagneten der Messvorrichtung gemäß Fig. 4 und der Messvorrichtung gemäß Fig. 5 erzeugten Magnetfeldes entlang des Pfades aufzeigt, entlang dem das Wertdokument durch die Messvorrichtung bewegt wird;
Fig. 7: eine schematische Seitenansicht einer Ausführungsform der Messvorrichtung zum Messen magnetischer Eigenschaften der Umgebung der Messvorrichtung mit zwei Vormagnetisierungsmagneten mit nichthomogener Magnetisierung, in der die Feldlinien des von den Vormagnetisierungsmagneten erzeugten magnetischen Felds eingezeichnet sind;
Fig. 8: eine Graphik, die den Verlauf des Betrags der Feldstärke des von den Vormagnetisierungsmagneten der Messvorrichtung gemäß Fig. 7 erzeugten Magnetfeldes entlang des Pfades aufzeigt, entlang dem das Wertdokument durch die Messvorrichtung bewegt wird;
Fig. 9: eine schematische Seitenansicht einer weiteren Ausführungsform der Messvorrichtung zum Messen magnetischer Eigenschaften der Umgebung der Messvorrichtung mit zwei Vormagnetisierungsmagneten mit nichthomogener Magnetisierung, in der die Feldlinien des von den Vormagnetisierungsmagneten erzeugten magnetischen Felds eingezeichnet sind;
Fig. 10: Graphik, die den Verlauf des Betrags der Feldstärke des von den Vormagnetisierungsmagneten der Messvorrichtung gemäß Fig. 9 erzeugten Magnetfeldes entlang des Pfades aufzeigt, entlang dem das Wertdokument durch die Messvorrichtung bewegt wird;
Fig. 11: eine schematische Seitenansicht einer der in Fig. 5 dargestellten vergleichbaren Ausführungsform der Messvorrichtung zum Messen magnetischer Eigenschaften der Umgebung der Messvorrichtung mit zwei Vormagnetisierungsmagneten mit nicht-homogener Magnetisierung, in der die Feldlinien des von den Vormagnetisierungs-magneten erzeugten magnetischen Felds eingezeichnet sind;
Fig. 12: eine Graphik, die den Verlauf des Betrags der Feldstärke des von den Vormagnetisierungsmagneten der Messvorrichtung gemäß Fig. 11 erzeugten Magnetfeldes entlang des Pfades aufzeigt, entlang dem das Wertdokument durch die Messvorrichtung bewegt wird;
Fig. 13: eine schematische Seitenansicht einer weiteren Ausführungsform der Messvorrichtung zum Messen magnetischer Eigenschaften der Umgebung der Messvorrichtung mit zwei Vormagnetisierungsmagneten mit nichthomogener Magnetisierung, in der die Feldlinien des von den Vormagnetisierungsmagneten erzeugten magnetischen Felds eingezeichnet sind;
Fig. 14: eine Graphik, die den Verlauf des Betrags der Feldstärke des von den Vormagnetisierungsmagneten der Messvorrichtung gemäß Fig. 13 erzeugten Magnetfeldes entlang des Pfades aufzeigt, entlang dem das Wertdokument durch die Messvorrichtung bewegt wird;
Fig. 15: eine schematische Seitenansicht einer nicht zur Erfindung gehörenden Messvorrichtung zum Messen magnetischer Eigenschaften der Umgebung der Messvorrichtung mit zwei Vormagnetisierungsmagneten mit nichthomogener Magnetisierung, in der die Feldlinien des von den Vormagnetisierungsmagneten erzeugten magnetischen Felds eingezeichnet sind;
Fig. 16: eine Graphik, die den Verlauf des Betrags der Feldstärke des von den Vormagnetisierungsmagneten der Messvorrichtung gemäß Fig. 15 erzeugten Magnetfeldes entlang des Pfades aufzeigt, entlang dem das Wertdokument durch die Messvorrichtung bewegt wird;
Fig. 17: eine schematische Seitenansicht einer nicht zur Erfindung gehörenden Messvorrichtung zum Messen magnetischer Eigenschaften der Umgebung der Messvorrichtung mit zwei Vormagnetisierungsmagneten mit nichthomogener Magnetisierung, in der die Feldlinien des von den Vormagnetisierungsmagneten erzeugten magnetischen Felds eingezeichnet sind;
Fig. 18: eine Graphik, die den Verlauf des Betrags der Feldstärke des von den Vormagnetisierungsmagneten der Messvorrichtung gemäß Fig. 17 erzeugten Magnetfeldes entlang des Pfades aufzeigt, entlang dem das Wertdokument durch die Messvorrichtung bewegt wird;
Fig. 19: eine schematische Seitenansicht einer weiteren Ausführungsform der Messvorrichtung zum Messen magnetischer Eigenschaften der Umgebung der Messvorrichtung mit zwei Vormagnetisierungsmagneten mit nichthomogener Magnetisierung, in der die Feldlinien des von den Vormagnetisierungsmagneten erzeugten magnetischen Felds eingezeichnet sind;
Fig. 20: eine Graphik, die den Verlauf des Betrags der Feldstärke des von den Vormagnetisierungsmagneten der Messvorrichtung gemäß Fig. 19 erzeugten Magnetfeldes entlang des Pfades aufzeigt, entlang dem das Wertdokument durch die Messvorrichtung bewegt wird;
Fig. 21: eine schematische Seitenansicht einer weiteren Ausführungsform der Messvorrichtung zum Messen magnetischer Eigenschaften der Umgebung der Messvorrichtung mit einem Vormagnetisierungsmagneten mit nichthomogener Magnetisierung, in der die Feldlinien des von den Vormagnetisierungsmagneten erzeugten magnetischen Felds eingezeichnet sind und dessen Gesamtdipolmoment Null beträgt;
Fig. 22: eine Graphik, die den Verlauf des Betrags der Feldstärke des von den Vormagnetisierungsmagneten der Messvorrichtung gemäß Fig. 21 erzeugten Magnetfeldes entlang des Pfades aufzeigt, entlang dem das Wertdokument durch die Messvorrichtung bewegt wird;
Fig. 23: eine schematische Seitenansicht eines Ausschnitts einer nicht zur Erfindung gehörenden Messvorrichtung mit nur einem Vormagnetisierungsmagnet, der aus einem einzigen Magnetblock besteht, dessen inhomogene Magnetisierung zu einer einseitigen Feldkonzentration führt und
Fig. 24: eine schematische Seitenansicht einer Ausführungsform der Messvorrichtung zum Messen magnetischer Eigenschaften der Umgebung der Messvorrichtung mit vier Vormagnetisierungsmagneten mit nichthomogener Magnetisierung, in der die Feldlinien des von den Vormagnetisierungsmagneten erzeugten magnetischen Felds eingezeichnet sind.

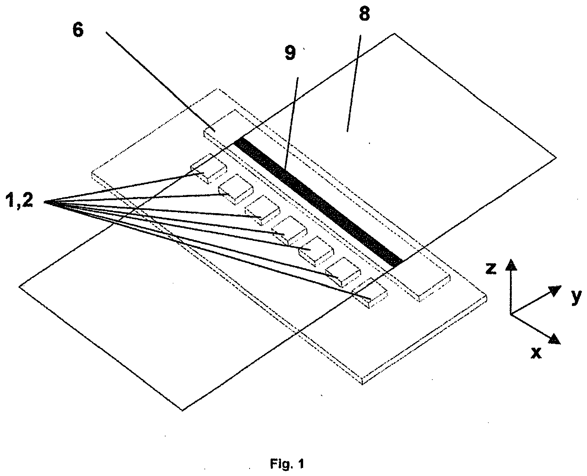

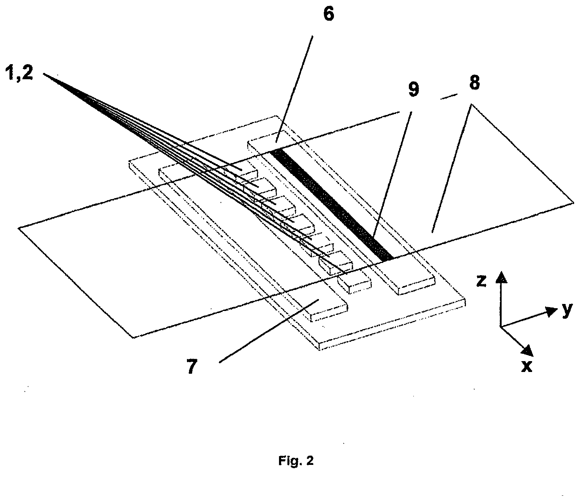

In Fig. 1 und 2 sind zwei Ausführungsformen von Messvorrichtungen zum Messen magnetischer Eigenschaften der Umgebung der Messvorrichtung gezeigt, nämlich eine Messvorrichtung zum Prüfen von Scheinen oder Bögen, insbesondere von Geldscheinen, Schecks oder anderen Papierbögen auf das Vorhandensein magnetischer Merkmale, insbesondere daraufhin, ob die Scheine oder Bögen besondere, vorher festgelegte magnetische Merkmale aufweisen.

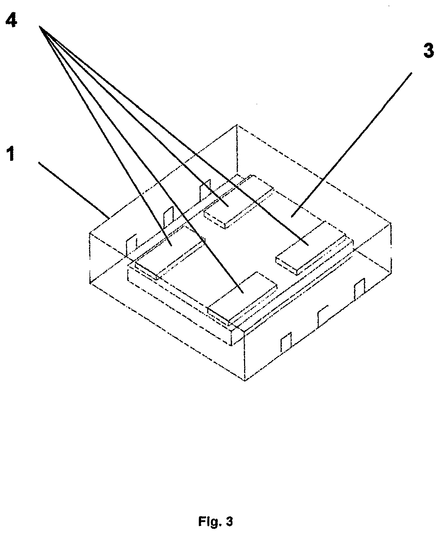

Die in den Figuren 1 und 2 dargestellten Messvorrichtungen weisen jeweils eine Sensorzeile 2, bestehend aus Sensorelementen 1 auf. Wie in Fig. 3 ersichtlich, weist ein Sensorelemente 1 auf einem Substrat 3 aufgebrachte magnetoresistive Brückenwiderstände 4 auf, die zu einer Wheatstone'schen Brücke verschaltet sind. Die Brückenwiderstände 4 weisen den AMR-Effekt auf. Mit dieser Brückenschaltung kann das Sensorelement 1 magnetische Eigenschaften seiner Umgebung messen, insbesondere die Änderung der Feldstärke einer Feldkomponente. Die in den Figuren 1 und 2 dargestellten Sensorzeilen weisen sieben in Zeilenrichtung nebeneinander angeordnete Sensorelemente 1 auf.

Die in den Figuren 1 und 2 dargestellten Messvorrichtungen weisen jeweils eine Stützfeldvorrichtung 5 auf, die in dem Bereich, in dem sich die Sensorzeile 2 erstreckt, ein magnetisches Stützfeld erzeugt.

In den Figuren 1 und 2 ist ferner ein Wertdokument 8 mit einem Sicherheitsmerkmal 9 dargestellt.

Ferner weisen die in den Figuren 1 und 2 dargestellten Messvorrichtungen jeweils eine Vormagnetisierungsvorrichtung auf. Bei der in der Figur 1 dargestellten Ausführungsform weist die Vormagnetisierungsvorrichtung einen Vormagnetisierungsmagneten 6 auf, der in einer zur Zeilenrichtung senkrechten Richtung von der Sensorzeile 1 beabstandet angeordnet ist und sich in einer Richtung parallel zur Zeilenrichtung erstreckt. Die in Fig. 2 dargestellte Ausführungsform weist eine Vormagnetisierungsvorrichtung auf, die einen ersten Vormagnetisierungsmagneten 6 aufweist, der in einer zur Zeilenrichtung senkrechten Richtung von der Sensorzeile 1 beabstandet angeordnet ist und sich in einer Richtung parallel zur Zeilenrichtung erstreckt. Ferner weist die Fig. 2 dargestellte Ausführungsform eine Vormagnetisierungsvorrichtung mit einem zweiten Vormagnetisierungsmagneten 7 auf, der in einer Richtung von der Sensorzeile 1 beabstandet angeordnet ist, die zu der Richtung, in die der erste Vormagnetisierungsmagnet 6 beabstandet zur Sensorzeile 1 angeordnet ist, entgegengesetzt ist.

In den nachfolgenden Figuren wird der in Fig. 1 und 2 dargestellte Träger, auf dem die Sensorelemente 1 und die Vormagnetisierungsmagnete 6, 7 angeordnet sind, aus Gründen der Übersichtlichkeit nicht dargestellt.

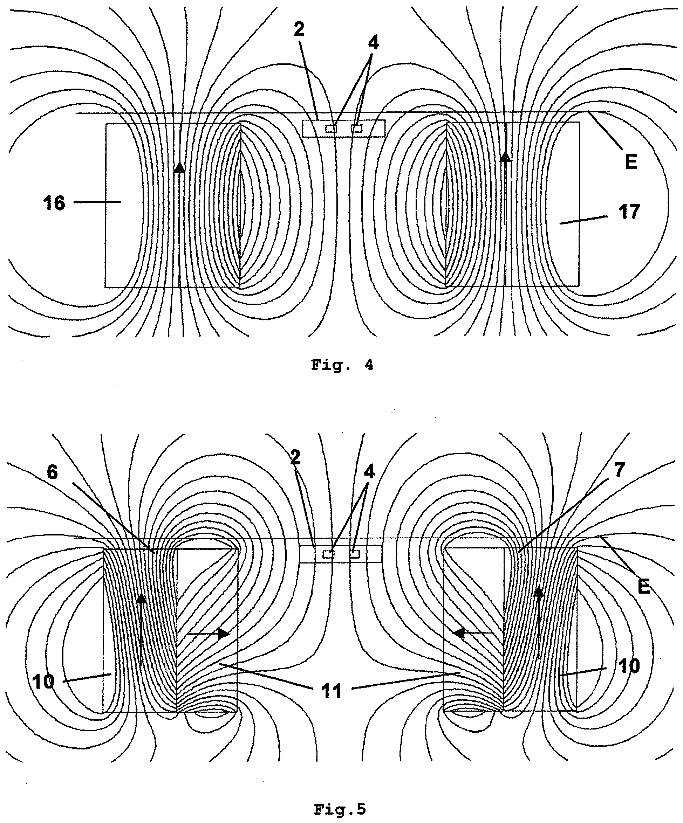

Die in Fig. 4 schematisch dargestellte, nicht zur Erfindung gehörende Messvorrichtung weist einen in Bewegungsrichtung des Wertdokuments vor und einen in Bewegungsrichtung hinter der Sensorzeile 2 angeordneten Vormagnetisierungsmagneten 16, bzw. 17 auf. Die Vormagnetisierungsmagneten 16 und 17 weisen homogene Magnetisierungen auf und sind als längliche Blockmagneten (Längserstreckung in die Papierebene) ausgeführt. Die in Fig. 4 eingezeichneten Feldlinien zeigen die üblichen, bei homogenen Magnetisierungen auftretenden Randabweichungen der Feldlinien von dem strikt parallelen Verlauf. In Fig. 4 ist ferner die Ebene E eingezeichnet, in der das Wertdokument 8 durch die Messvorrichtung geführt wird - in der Fig. 4 von links nach rechts. Der Wert der in Längsrichtung der Vormagnetisierungsmagneten 16 und 17 weisenden Magnetfeldkomponente (Magnetfeldkomponente in die Papierebene) ist im Wesentlichen null.

Die in Fig. 5 schematisch dargestellte Messvorrichtung weist einen in Bewegungsrichtung des Wertdokuments vor und einen in Bewegungsrichtung hinter der Sensorzeile 2 angeordneten Vormagnetisierungsmagneten 6, bzw. 7 auf. Die Vormagnetisierungsmagneten 6 und 7 weisen nicht-homogene Magnetisierungen auf. Die Vormagnetisierungsmagneten 6 und 7 werden nach Art eines Halbach-Arrays dadurch hergestellt, dass ein erster Permanentmagnet 10 mit einer homogenen Magnetisierung, die in eine erste Richtung (in der Fig. 5 durch den nach oben weisenden Pfeil dargestellt) weist, mit einem zweiten Permanentmagnet 11 mit einer homogenen Magnetisierung verbunden wird, die in eine zweite Richtung (in der Fig. 5 durch den nach rechts, bzw. nach links weisenden Pfeil dargestellt) weist. Dadurch wird ein Vormagnetisierungsmagnet geschaffen, dessen Magnetisierung sich über die Erstreckung seines Festkörpers um ca. 90° dreht (vgl. die Ausrichtung der Feldlinien in dem oberen, linken Bereich des Permanentmagneten 10 zu dem Verlauf der Feldlinien im unteren, rechten Bereich des Permanentmagneten 11). Der Wert der in Längsrichtung der Vormagnetisierungsmagneten 6 und 7 weisenden Magnetfeldkomponente (Magnetfeldkomponente in die Papierebene) ist im Wesentlichen null. Die in der Fig. dargestellten Feldlinien geben das aus der Überlagerung des Magnetfelds des ersten Permanentmagneten 10 und des zweiten Permanentmagneten 11 entstehende Magnetfeld des Vormagnetisierungsmagneten 6 wieder, bzw. genauer gesagt, das sich aus der Überlagerung des von dem Vormagnetisierungsmagneten 6 erzeugten Magnetfeld mit dem von dem Vormagnetisierungsmagneten 7 erzeugten Magnetfeld entstehende Magnetfeld.

Da es sich bei den Permanentmagneten 10 und 11 um Magneten mit (wenn in Isolation betrachtet) homogenem Magnetfeld handelt, ist der Verlauf der Magnetisierungskomponente der Magnetisierung des ersten Magneten 10 in die erste Richtung (beispielsweise die vertikale Richtung) homogen und der Verlauf der Magnetisierungskomponente der Magnetisierung des ersten Magneten in die zweite Richtung (beispielsweise die horizontale, von rechts nach links gerichtete Richtung) homogen (nämlich im wesentlichen null) und der Verlauf der Magnetisierungskomponente der Magnetisierung des ersten Magneten in die dritte Richtung (beispielsweise die horizontale, in die Papierebene weisende Richtung) homogen (nämlich im wesentlichen null). Der Verlauf der Magnetisierungskomponente der Magnetisierung des zweiten Magneten 11 in die erste Richtung ist (nämlich im Wesentlichen null). Der Verlauf der Magnetisierungskomponente der Magnetisierung des zweiten Magneten in die zweite Richtung ist homogen (vgl. den Pfeil im Permanentmagneten 11). Der Verlauf der Magnetisierungskomponente der Magnetisierung des zweiten Magneten in die dritte Richtung ist homogen (nämlich im Wesentlichen null). Daraus ergibt sich, dass
- der Verlauf der Magnetisierungskomponente des ersten Magneten in die erste Richtung unterschiedlich ist zum Verlauf der Magnetisierungskomponente des zweiten Magneten in die erste Richtung und
- der Verlauf der Magnetisierungskomponente des ersten Magneten in die zweite Richtung unterschiedlich ist zum Verlauf der Magnetisierungskomponente des zweiten Magneten in die zweite Richtung. Der Verlauf der Magnetisierungskomponente des ersten Magneten in die dritte Richtung ist gleich zum Verlauf der Magnetisierungskomponente des zweiten Magneten in die dritte Richtung. In diese dritte Richtung ist bei beiden Magneten die Magnetisierungskomponente im Wesentlichen gleich null.

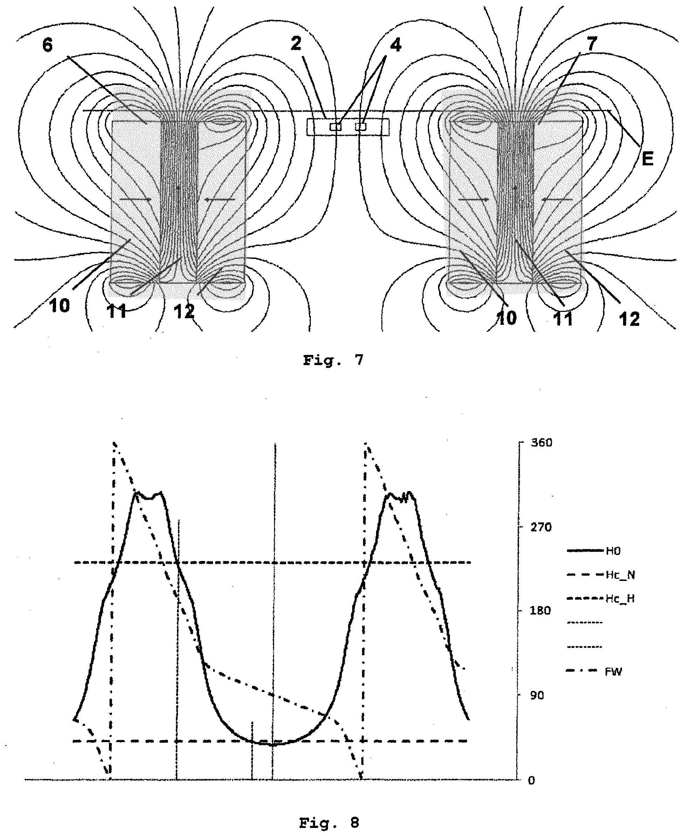

In der Fig. 5 ist zu erkennen, dass die Feldlinien des durch die Vormagnetisierungsmagneten 6 und 7 erzeugten Magnetfelds im Bereich der Brückenwiderstände 4 der Sensorzeile 2 im Wesentlichen vertikal verlaufen und damit senkrecht zur Zeilenrichtung der Sensorzeile (Erstreckung in die Papierebene) und senkrecht zur Breite der Sensorzeile (Erstreckung rechts/links in Fig. 5). Da jedoch in dem Bereich der Ebene E, der unmittelbar oberhalb der Sensorzeile 2 liegt, noch ein Magnetfeld vorhanden ist, lassen sich mit diesem Magnetfeld weichmagnetische Strukturen auf dem Wertdokument 8 so magnetisieren, dass sie von der Sensorzeile 2 erkannt werden können. Gleiches gilt bzgl. der weichmagnetischen Strukturen bei den Ausführungsformen der Fig. 7, 9, 11, 13, 15.

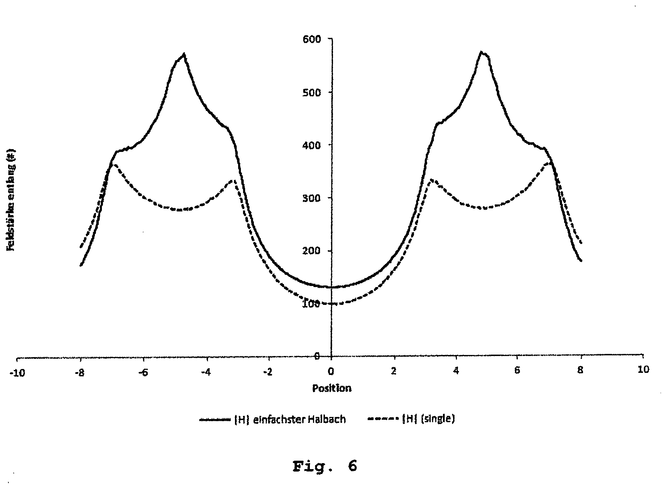

Die Fig. 6 zeigt den Verlauf des Betrags der Magnetfeldstärke entlang des Pfads in der Ebene E, entlang dem das Wertdokument 8 durch die Messvorrichtung geführt wird. Als durchgezogene Linie wird die Magnetfeldstärke des durch die Vormagnetisierungsmagneten 6 und 7 der Messvorrichtung gemäß Fig. 5 erzeugten Magnetfeldes gezeigt. Als unterbrochene Linie wird die Magnetfeldstärke des durch die Vormagnetisierungsmagneten 16 und 17 der Messvorrichtung gemäß Fig. 4 erzeugten Magnetfeldes gezeigt. Beide Magnetfelder haben die gleiche Dimension, d.h. das gleiche magnetische Volumen. Man erkennt, dass sich die maximale Feldstärke des bei der Vorrichtung erzeugten Vormagnetisierungsfelds gegenüber dem eines herkömmlichen Blockmagneten fast verdoppeln lässt.

Die in Fig. 7 dargestellte Ausführungsform der Erfindung unterscheidet sich von der in Fig. 5 dargestellten dadurch, dass die Vormagnetisierungsmagneten 6 und 7 jeweils durch das Zusammenfügen von insgesamt 3 Permanentmagneten 10, 11, 12 mit jeweils homogener, aber in unterschiedliche Richtung weisenden Magnetisierungen gebildet werden.

Die Fig. 8 zeigt den Verlauf des Betrags der Magnetfeldstärke entlang des Pfads in der Ebene E, entlang dem das Wertdokument 8 durch die Messvorrichtung geführt wird. Als durchgezogene Linie wird die Magnetfeldstärke des durch die Vormagnetisierungsmagneten 6 und 7 der Messvorrichtung gemäß Fig. 7 erzeugten Magnetfeldes gezeigt. Als unterbrochene Linie HC_N wird die Koerzitivfeldstärke eines niedrigkoerzitiven magnetischen Materials auf dem Wertdokument 8 gezeigt. Als weniger stark unterbrochene Linie HC_H wird die Koerzitivfeldstärke eines hochkoerzitiven magnetischen Materials auf dem Wertdokument 8 gezeigt. Die dünnen gestrichelten, vertikal verlaufenden Linien zeigen den Punkt entlang des Pfads in der Ebene E, entlang dem das Wertdokument 8 durch die Messvorrichtung geführt wird, an dem der Betrag des Magnetfelds (durchgezogene Linie) die Koerzitivfeldstärke des niedrigkoerzitiven, bzw. des hochkoerzitiven magnetischen Materials schneidet. An diesem Punkt "friert" die Magnetisierung des jeweiligen magnetischen Materials ein. Das magnetische Material auf dem Wertdokument hat dann eine Magnetisierung, die in eine Richtung weist, die das Magnetfeld zu dem Zeitpunkt hatte, an dem der Betrag des Magnetfelds (durchgezogene Linie) die Koerzitivfeldstärke des niedrigkoerzitiven, bzw. des hochkoerzitiven magnetischen Materials schneidet. Die Fig. 8 zeigt als strichpunktierte Linie den Verlauf des Feldwinkels des durch die Vormagnetisierungsmagneten 6 und 7 der Messvorrichtung gemäß Fig. 7 erzeugten Magnetfeldes entlang des Pfads in der Ebene E, entlang dem das Wertdokument 8 durch die Messvorrichtung geführt wird. Der in dem Graph der Fig. 8 vorgesehene Maßstab auf der rechten Seite zeigt die Winkel an. Für den Betrag der Magnetfeldstärke ist kein Maßstab vorgesehen. Schneidet man die dünnen gestrichelten Linien mit der strichpunktierten Linie, so erhält man daraus den Feldwinkel, in den das Magnetfeld weist, wenn die Magnetisierung des magnetischen Materials "einfriert". Man erkennt, dass das Magnetfeld bei dem niedrigkoerzitiven magnetischen Material in eine andere Richtung weist, als bei dem hochkoerzitiven Material. Bei dem niedrigkoerzitiven Material liegt der Winkel bei ca. 90°, bei dem hochkoerzitiven Material etwas oberhalb von 180°. Die "eingefrorene" Magnetisierung des niedrigkoerzitiven Materials weist somit in eine um ca. 90° unterschiedliche Richtung zu der "eingefrorenen" Magnetisierung des hochkoerzitiven Materials.

Diese um 90° unterschiedlichen Magnetisierungen der magnetischen Materialien lassen sich durch die Sensorzeile 2 durch Auswertung der Signalverläufe erfassen. Wird auf dem Wertdokument ein Sicherheitsmerkmal aus dem hochkoerzitiven Material und ein Sicherheitsmerkmal aus dem niedrigkoerzitiven Material vorgesehen, so kann die Sensorzeile 2 deren Vorhandensein und deren Verortung entlang der Sensorzeile erkennen. Da die Sensorzeile die unterschiedliche Richtung der Magnetisierung erkennen kann, kann die Sensorzeile auch erkennen, ob an dem Ort ein Sicherheitsmerkmal aus hochkoerzitivem Material oder ein Sicherheitsmerkmal aus niedrigkoerzitivem Material vorhanden ist.

Es sind auch Wertdokumente bekannt, die ein Sicherheitsmerkmal haben, das aus hochkoerzitivem Material und niedrigkoerzitivem Material hergestellt wird. Bei diesen Sicherheitsmerkmalen wird hochkoerzitives Material in unmittelbarer Nachbarschaft zum niedrigkoerzitiven Material vorgesehen. Die Magnetisierung der beiden das Sicherheitsmerkmal bildenden magnetischen Materialien erfolgt auf gleiche Weise: die Magnetisierung des hochkoerzitiven Materials "friert" an dem einen Punkt entlang des Weges des Wertdokuments 8 entlang der Ebene E ein und erhält die zu diesem Zeitpunkt vorherrschende Magnetisierungsrichtung (etwas über 180° in dem Beispiel der Fig. 7 und 8), während die Magnetisierung des niedrigkoerzitiven Materials an dem anderen Punkt entlang des Weges des Wertdokuments 8 entlang der Ebene E einfriert und die zu diesem Zeitpunkt vorherrschende Magnetisierungsrichtung erhält (ca. 90° in dem Beispiel der Fig. 7 und 8). Da die Richtungen der so erzeugten Magnetisierungen der magnetischen Materialien nur um ca. 90° und nicht beispielsweise um 180° zueinander ausgerichtet sind, heben sich die Magnetisierungen nicht auf. Das aus den beiden magnetischen Materialien gebildete Sicherheitsmerkmal erhält eine Gesamtmagnetisierung mit einem Betrag und einer Magnetisierungsrichtung, die durch die Sensorzeile 2 erkannt werden kann. Damit kann die Messvorrichtung auch Sicherheitsmerkmale erkennen, die aus hochkoerzitivem Material und niedrigkoerzitiven Material hergestellt werden.

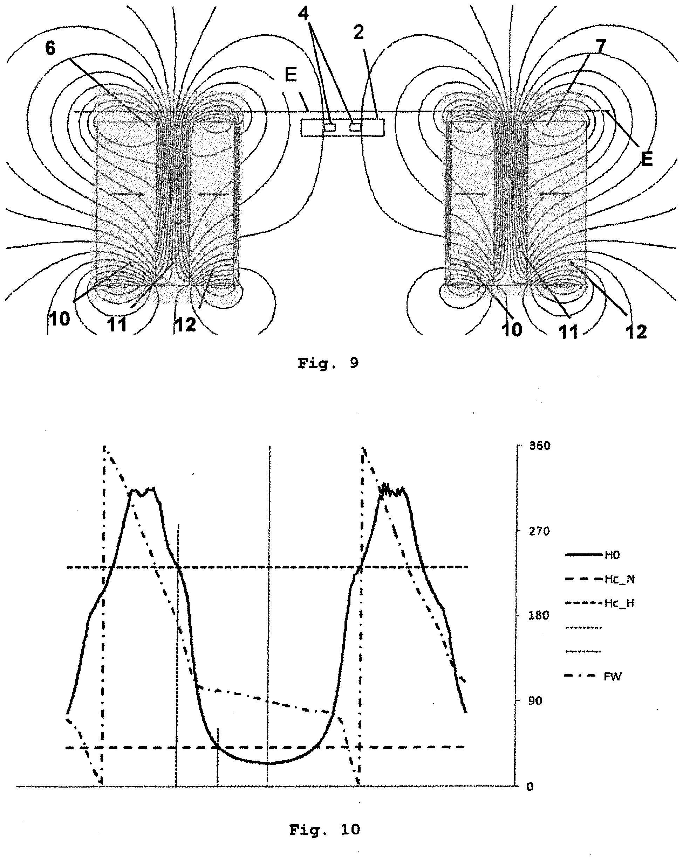

Die in Fig. 9 dargestellte Ausführungsform der Erfindung unterscheidet sich von der in Fig. 7 dargestellten dadurch, dass die Vormagnetisierungsmagneten 6 und 7 zusätzlich zu den insgesamt 3 Permanentmagneten 10, 11, 12 noch ein Blech 13 aufweisen. Dieses Blech 13 schirmt die Sensorzeile 2 etwas von dem durch die Vormagnetisierungsmagneten 6 und 7 erzeugten Magnetfeld ab, wie man bei einem Vergleich der Fig. 7 mit der Fig. 9 an dem Verlauf der Feldlinien und der Feldliniendichte leicht erkennen kann.

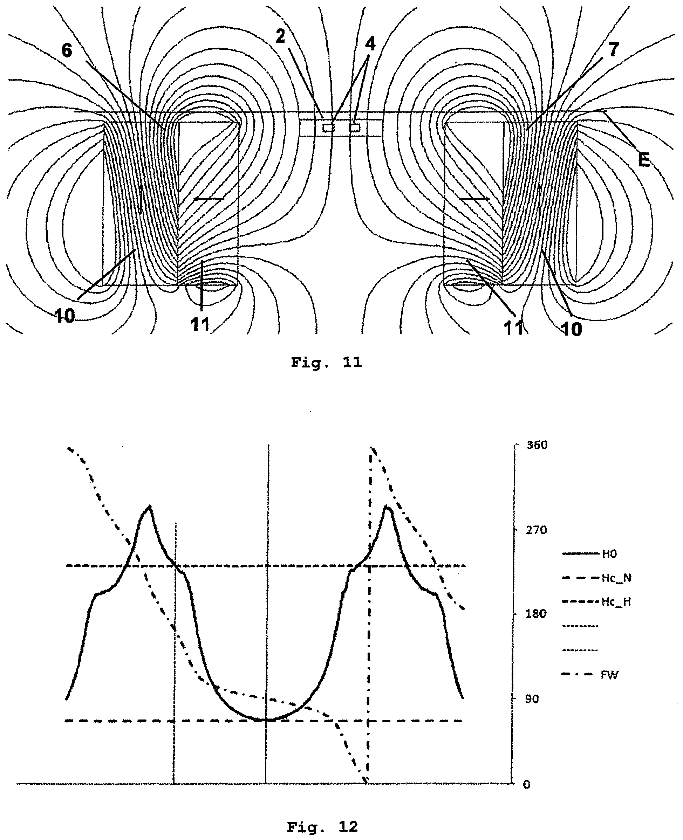

Die in Fig. 11 dargestellte Ausführungsform ist der in Fig. 5 dargestellten Ausführungsform vergleichbar aufgebaut. Sie unterscheidet sich in der Magnetisierungsrichtung des Permanentmagneten 11. Fig. 12 zeigt die den Fig. 10 und 8 vergleichbare Auswertung des Verlaufs der Feldstärke und des Feldwinkels und die Punkte, an denen die Magnetisierung des hochkoerzitiven Materials, bzw. des niedrigkoerzitiven Materials "einfriert".

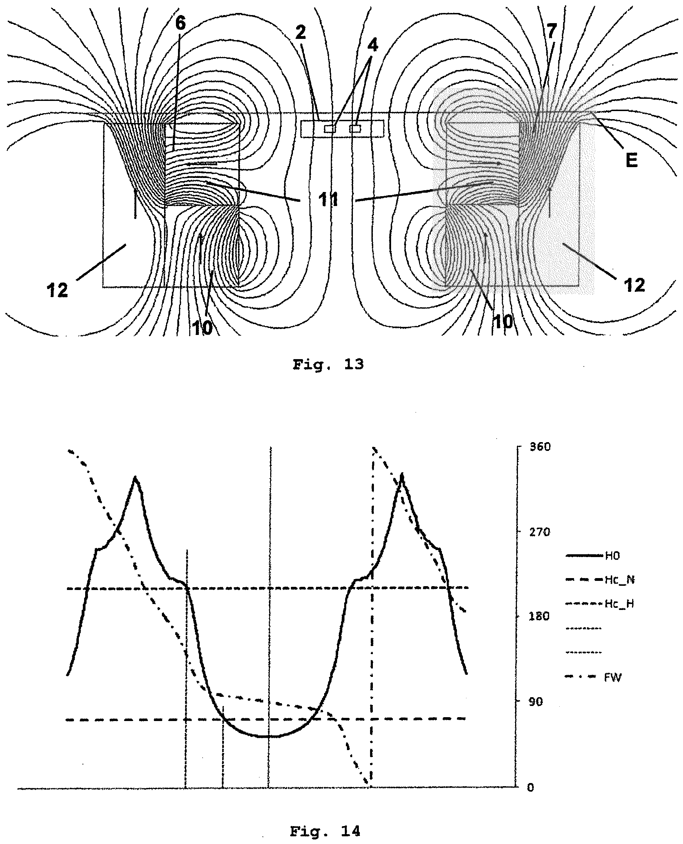

Die in Fig. 13 dargestellte Ausführungsform der Erfindung unterscheidet sich von den vorher beschriebenen Ausführungsformen durch den Aufbau der Vormagnetisierungsmagneten 6, 7. Diese sind bei der Ausführungsform gemäß Fig. 13 aus 3 Permanentmagneten mit unterschiedlicher, homogener Magnetisierung aufgebaut. Fig. 14 zeigt die den Fig. 10 und 8 vergleichbare Auswertung des Verlaufs der Feldstärke und des Feldwinkels und die Punkte, an denen die Magnetisierung des hochkoerzitiven Materials, bzw. des niedrigkoerzitiven Materials "einfriert".

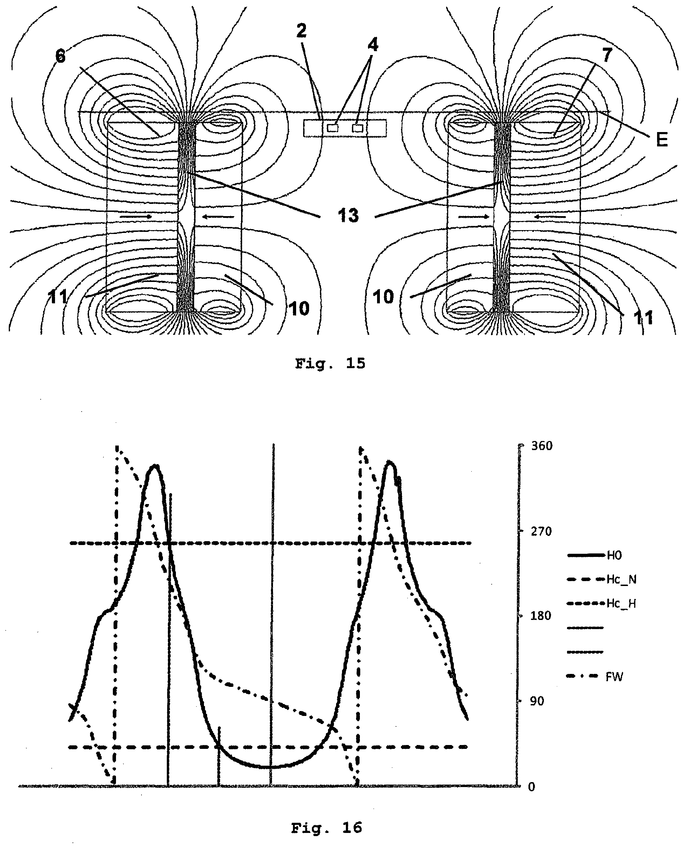

Die in Fig. 15 dargestellte, nicht zur Erfindung gehörende Ausführungsform unterscheidet sich von den vorher beschriebenen Ausführungsformen durch den Aufbau der Vormagnetisierungsmagneten 6, 7. Diese sind bei der Ausführungsform gemäß Fig. 15 durch 2 Permanentmagneten mit unterschiedlicher, homogener Magnetisierung aufgebaut, deren Magnetisierungsrichtung um 180° gedreht ist. Ein zwischen den die Vormagnetisierungsmagnete 6, 7 bildenden Permanentmagneten 10, 11 angeordnetes Blech 13 dient der Flussführung des magnetischen Flusses. Fig. 16 zeigt die den Fig. 10 und 8 vergleichbare Auswertung des Verlaufs der Feldstärke und des Feldwinkels und die Punkte, an denen die Magnetisierung des hochkoerzitiven Materials, bzw. des niedrigkoerzitiven Materials "einfriert".

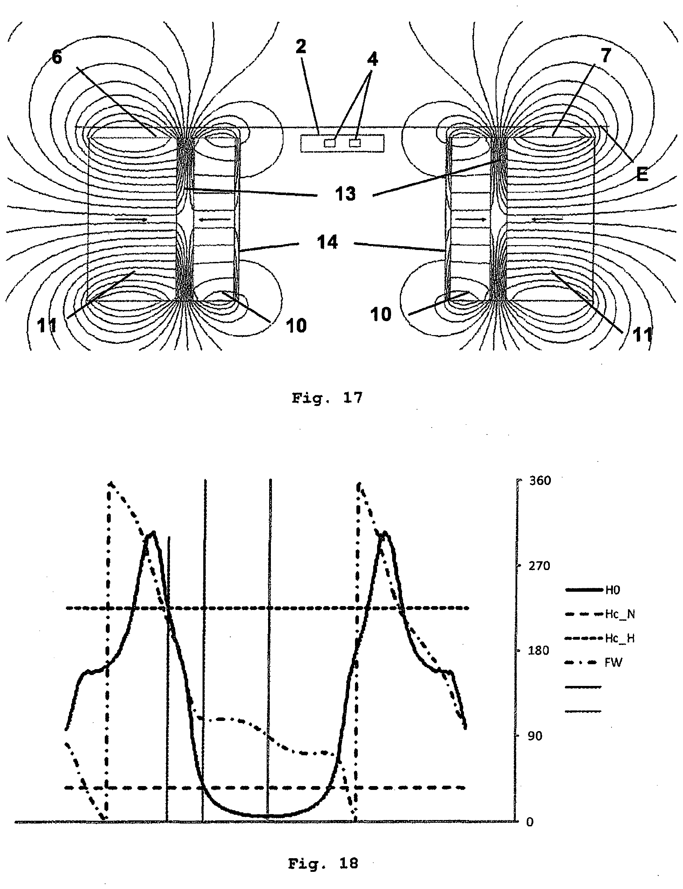

Die in Fig. 17 dargestellte, nicht zur Erfindung gehörende Ausführungsform entwickelt die in Fig. 15 dargestellte Ausführungsform weiter. Das am Rand der Vormagnetisierungsmagneten 6 und 7 jeweils vorgesehene Blech 14 schirmt die Sensorzeile ab, so dass nur ein sehr kleines Feld am Sensor verbleibt.

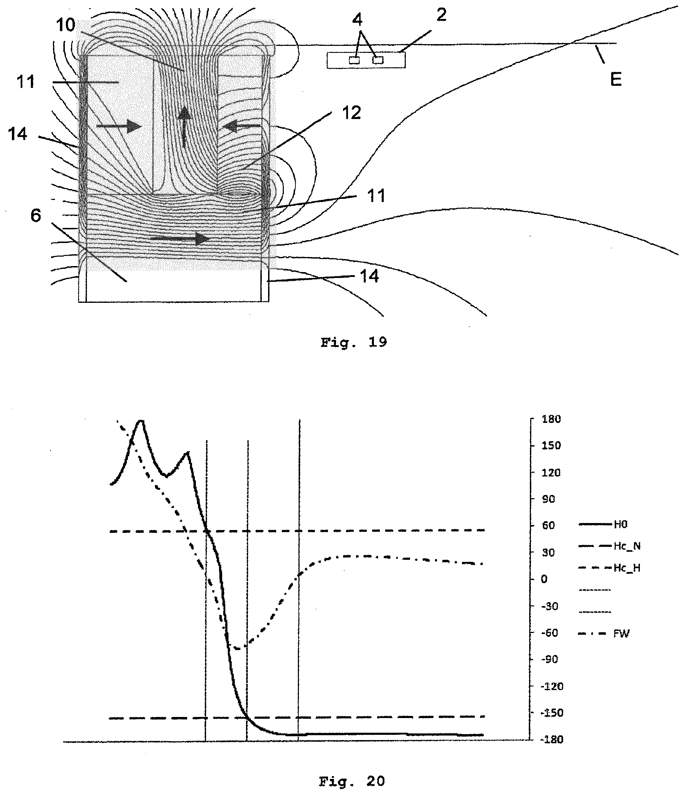

Die Ausführungsform der Fig. 19 zeigt einen der Ausführungsform gemäß Fig. 1 vergleichbaren Aufbau, bei dem nur ein Vormagnetisierungsmagnet 6 vorgesehen ist. Dieser besteht aus 3 Permanentmagneten mit jeweils homogener, aber zueinander unterschiedliche ausgerichteter Magnetisierung sowie aus randseitig vorgesehenen Blechen 13, 14. Der Vormagnetisierungsmagnet ist so konstruiert, dass das Feld auf der rechten Seite nahezu sofort gegen null fällt, um den Platzbedarf möglichst klein zu halten. Da das Magnetfeld des Vormagnetisierungsmagnet an seinem rechten Rand nahezu auf null fällt, kann der Vormagnetisierungsmagnet in unmittelbarer Nähe zu Sensorzeile 2 angeordnet werden, ohne dass die Gefahr besteht, dass das Vormagnetisierungsmagnetfeld die Messwertaufnahme der Sensorzeile 2 stört, bzw. ein Stützfeld der Sensorzeile 2 stört.

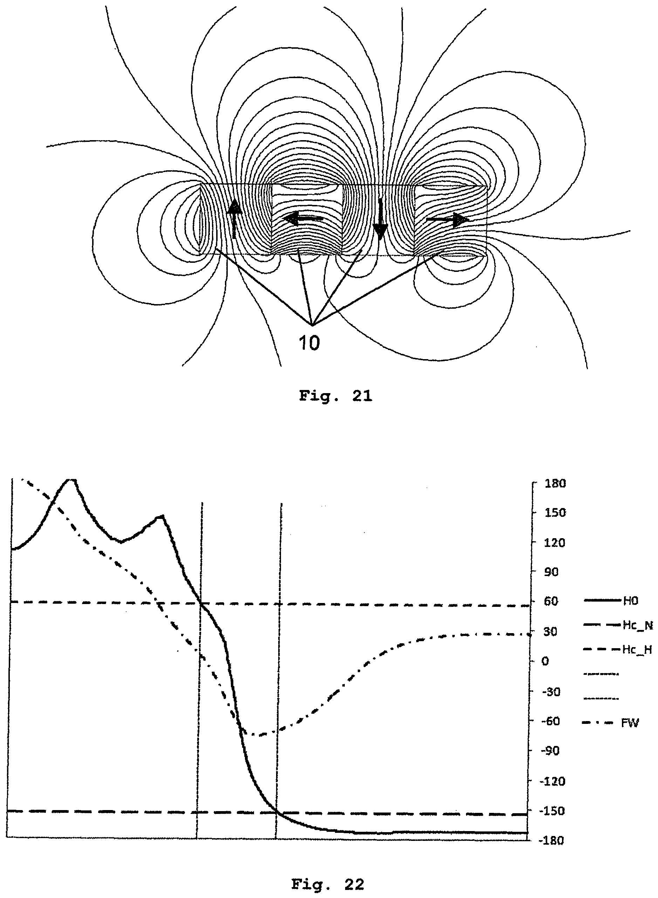

Die Ausführungsform der Fig. 21 zeigt eine Ausführungsform, bei der nur ein Vormagnetisierungsmagnet 6 vorgesehen ist. Dieser besteht aus 4 Permanentmagneten mit jeweils homogener, aber zueinander unterschiedlich ausgerichteter Magnetisierung. Der Vormagnetisierungsmagnet ist so konstruiert, dass die Dipolmomente der Einzelkomponenten entgegengesetzt orientiert sind und sich damit in der Summe aufheben. Hierdurch erzeugt diese Ausführungsform nur Multipolfelder höherer Ordnung. Derartige Felder fallen mit wachsendem Abstand sehr viel schneller gegen Null ab, als bei einem Dipolfeld. Hierdurch wird einerseits die Feldstärke im Nahbereich erhöht, andererseits sind geringere Abstände zur benachbarten Messvorrichtung möglich.

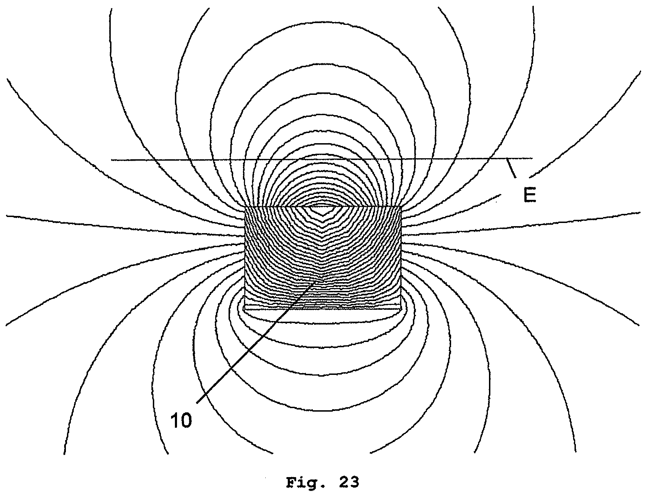

Die Ausführungsform der Fig. 23 zeigt eine nicht zur Erfindung gehörende Ausführungsform bei der nur ein Vormagnetisierungsmagnet 6 vorgesehen ist. Dieser besteht aus einem einzigen Magnetblock, dessen inhomogene Magnetisierung zu einer einseitigen Feldkonzentration führt.

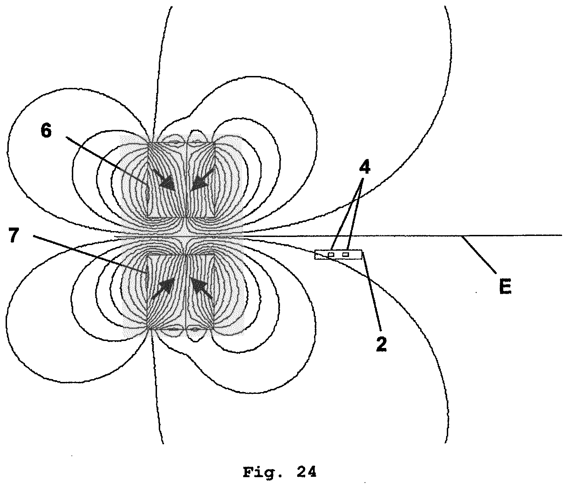

Die Ausführungsform der Fig. 24 zeigt, dass die als Teil einer Vormagnetisierungsvorrichtung vorgesehenen Vormagnetisierungsmagneten auch so angeordnet werden können, dass zwei Vormagnetisierungsmagneten 6,7 übereinander angeordnet sind und die Ebene E zwischen den beiden Vormagnetisierungsmagneten 6,7 hindurchführen kann. Die in Fig. 24 schematisch dargestellte Messvorrichtung weist ein Paar von in Bewegungsrichtung des Wertdokuments vor der Sensorzeile 2 angeordneten Vormagnetisierungsmagneten 6, bzw. 7 auf. Die das Paar bildenden Vormagnetisierungsmagneten 6 und 7 weisen jeweils eine nicht-homogene Magnetisierungen auf. Die Vormagnetisierungsmagneten 6 und 7 werden nach Art eines Halbach-Arrays dadurch hergestellt, dass ein erster Permanentmagnet mit einer homogenen Magnetisierung, die in eine erste Richtung (in der Fig. 24 durch den nach oben rechts weisenden Pfeil des Vormagnetisierungsmagneten 7 dargestellt) weist, mit einem zweiten Permanentmagnet mit einer homogenen Magnetisierung verbunden wird, die in eine zweite Richtung (in der Fig. 24 durch den oben links weisenden Pfeil des Vormagnetisierungsmagneten 7 dargestellt) weist. Dadurch wird ein Vormagnetisierungsmagnet geschaffen, dessen Magnetisierung sich über die Erstreckung seines Festkörpers dreht (vgl. die Ausrichtung der Feldlinien in dem oberen, linken Bereich des Vormagnetisierungsmagneten 7 zu dem Verlauf der Feldlinien im oberen, rechten Bereich des Vormagnetisierungsmagneten 7).

## Patentansprüche

1. Verfahren zur Vormagnetisierung magnetischer Materialien auf einem Messobjekt mit einem ersten magnetischen Material mit einer ersten Koerzitivfeldstärke und einem zweiten magnetischen Material mit einer zweiten Koerzitivfeldstärke, die niedriger ist als die erste Koerzitivfeldstärke, wobei das Messobjekt nach der Vormagnetisierung einer Sensorzeile (2) einer Messvorrichtung zum Messen magnetischer Eigenschaften der Umgebung der Messvorrichtung zugeführt wird, wobei das Messobjekt von einem ersten Punkt zu einem zweiten Punkt und dann zu einem dritten Punkt durch ein Vormagnetisierungsfeld einer Vormagnetisierungsvorrichtung geführt wird, wobei die Vormagnetisierungsvorrichtung mindestens einen Vormagnetisierungsmagneten aufweist, wobei
- die Feldstärke des Vormagnetisierungsfelds am ersten Punkt größer ist als die erste und größer ist als die zweite Koerzitivfeldstärke,
- die Feldstärke des Vormagnetisierungsfelds am zweiten Punkt größer ist als die zweite Koerzitivfeldstärke und nach Verlassen des zweiten Punkts unter die erste Koerzitivfeldstärke fällt und während der Bewegung des Messobjekts vom zweiten zum dritten Punkt nicht mehr über die erste Koerzitivfeldstärke steigt und die Feldrichtung des Vormagnetisierungsfelds am zweiten Punkt in eine erste Richtung weist und
- die Feldstärke des Vormagnetisierungsfelds beim Erreichen des dritten Punkts unter die zweite Koerzitivfeldstärke fällt und während der Bewegung des Messobjekts vom dritten zur Sensorzeile (2) nicht mehr über die zweite Koerzitivfeldstärke steigt und die Feldrichtung des Vormagnetisierungsfelds am dritten Punkt in eine zweite Richtung weist, die unterschiedlich zur ersten Richtung ist, **dadurch gekennzeichnet, dass** als Vormagnetisierungsmagnet ein Vormagnetisierungsmagnet (6, 7) zur Vormagnetisierung magnetischer Materialien auf einem Messobjekt, das nach der Vormagnetisierung einer Sensorzeile (2) einer Messvorrichtung zum Messen magnetischer Eigenschaften der Umgebung der Messvorrichtung zugeführt wird, verwendet wird, bei dem die Magnetisierung des Vormagnetisierungsmagneten (6, 7) nicht homogen ist, wobei der Vormagnetisierungsmagnet ein Halbach-Array ist.

2. Verfahren nach Anspruch 1, **dadurch gekennzeichnet, dass** die Dipolmomente der einzelnen Magnetteile sich in der Gesamtsumme im Wesentlichen aufheben, so dass das Magnetfeld im Wesentlichen nur Multipolmomente aufweist.

3. Verfahren nach Anspruch 1 oder 2, **dadurch gekennzeichnet, dass** eine Messvorrichtung zum Messen magnetischer Eigenschaften der Umgebung der Messvorrichtung mit einer Sensorzeile mit mindestens einem sich in eine Zeilenrichtung erstreckenden magnetoresistiven Sensorelement, das magnetische Eigenschaften in seiner Umgebung messen kann, verwendet wird, wobei der Vormagnetisierungsmagnet (6, 7) Teil der Messvorrichtung ist.

4. Verfahren nach einem der Ansprüche 1 bis 3, **dadurch gekennzeichnet, dass** der Vormagnetisierungsmagnet (6, 7) eine Höhe, eine Breite und eine Länge aufweist, wobei die Länge größer ist als die Höhe und größer ist als die Breite und wobei die Längserstreckung des Vormagnetisierungsmagneten (6, 7) parallel zur Zeilenrichtung ausgerichtet ist.

5. Verfahren nach einem der Ansprüche 1 bis 4, **gekennzeichnet durch** einen ersten Vormagnetisierungsmagneten (6, 7) zur Vormagnetisierung magnetischer Materialien auf einem Messobjekt, das nach der Vormagnetisierung einer Sensorzeile (2) einer Messvorrichtung zum Messen magnetischer Eigenschaften der Umgebung der Messvorrichtung zugeführt wird, wobei die Magnetisierung des Vormagnetisierungsmagneten (6, 7) nicht homogen ist und einem zweiten Vormagnetisierungsmagneten (6, 7) zur Vormagnetisierung magnetischer Materialien auf einem Messobjekt, das nach der Vormagnetisierung einer Sensorzeile (2) einer Messvorrichtung zum Messen magnetischer Eigenschaften der Umgebung der Messvorrichtung zugeführt wird, wobei die Magnetisierung des Vormagnetisierungsmagneten (6, 7) nicht homogen ist, wobei der zweite Vormagnetisierungsmagnet (6, 7) in einer senkrecht zur Längserstreckung des ersten Vormagnetisierungsmagneten (6, 7) und senkrecht zur Zeilenrichtung weisenden Durchlaufrichtung vom ersten Vormagnetisierungsmagneten (6, 7) aus hinter der Sensorzeile (2) angeordnet ist oder senkrecht zur Durchlaufrichtung oberhalb des ersten Vormagnetisierungsmagneten (6, 7) angeordnet ist.

6. Verfahren nach einem der Ansprüche 1 bis 5, **dadurch gekennzeichnet, dass** das Sensorelement (1) eine Breite und eine Länge sowie eine Höhe aufweist, wobei die Höhe geringer ist als die Breite und die Höhe geringer ist als die Länge und die Zeilenrichtung in Richtung der Breite oder in Richtung der Länge des Sensorelements (1) weist und mit einer den Vormagnetisierungsmagneten (6, 7) aufweisenden Vormagnetisierungsvorrichtung und einer von der Vormagnetisierungsvorrichtung unterschiedlichen Stützfeldvorrichtung (5), die in dem Bereich, über den sich die Sensorzeile (2) erstreckt, ein magnetisches Stützfeld erzeugt, wobei der Vormagnetisierungsmagnet (6, 7) in einer zur Zeilenrichtung senkrechten Richtung von der Sensorzeile (2) beabstandet angeordnet ist und sich in einer Richtung parallel zur Zeilenrichtung erstreckt, wobei
- das magnetoresistive Sensorelement (1) im Wesentlichen nur in einer als Messrichtung bezeichneten Richtung eines orthogonalen Koordinatensystems oder im Wesentlichen nur in einer als Sensormessebene bezeichneten, durch zwei senkrechte Messrichtungen eines orthogonalen Koordinatensystems aufgespannten Ebene die magnetischen Eigenschaften seiner Umgebung messen kann,
- bei einer nur aus einem Vormagnetisierungsmagneten (6, 7) bestehenden Vormagnetisierungsvorrichtung die das von ihm erzeugte magnetische Feld beeinflussenden Eigenschaften des Vormagnetisierungsmagneten (6, 7) und seine Anordnung relativ zur Sensorzeile (2) sowie das von der Stützfeldvorrichtung (5) erzeugte Stützfeld derart gewählt sind, dass ein Überlagerungsmagnetfeld aus der Überlagerung des von der Vormagnetisierungsvorrichtung erzeugten Magnetfelds und des Stützfelds entsteht, dessen Stärke der in Zeilenrichtung weisenden Feldkomponente zumindest an einem Ort auf der Sensorzeile (2) größer ist als die Stärke der senkrecht zur Zeilenrichtung und nicht in Richtung der Höhe des Sensorelements (1) weisenden Feldkomponente, oder
- bei einer aus mehreren Vormagnetisierungsmagneten (6, 7) bestehenden Vormagnetisierungsvorrichtung die das von ihnen erzeugte magnetische Feld beeinflussenden Eigenschaften der Vormagnetisierungsmagneten (6, 7) und die Anordnung der Vormagnetisierungsmagneten (6, 7) relativ zur Sensorzeile (2) sowie das von der Stützfeldvorrichtung (5) erzeugte Stützfeld derart gewählt sind, dass ein Überlagerungsmagnetfeld aus der Überlagerung des von der Vormagnetisierungsvorrichtung erzeugten Magnetfelds und des Stützfelds entsteht, dessen Stärke der in Zeilenrichtung weisenden Feldkomponente zumindest an einem Ort auf der Sensorzeile (2) größer ist als die Stärke der senkrecht zur Zeilenrichtung und nicht in Richtung der Höhe des Sensorelements (1) weisenden Feldkomponente.

## Claims

1. Method for premagnetising magnetic materials on a measurement object with a first magnetic material with a first coercive field strength and a second magnetic material with a second coercive field strength which is lower than the first coercive field strength, wherein the measurement object, after the premagnetising of a sensor line (2) of a measurement device is supplied for measuring the magnetic properties of the environment of the measurement device, wherein the measurement object is taken from a first point to a second point and then to a third point through a premagnetising field of a premagnetising device, wherein the premagnetising device has at least one premagnetising magnet, wherein
- the field strength of the premagnetising field at the first point is greater than the first and is greater than the second coercive field strength,
- the field strength of the premagnetising field at the second point is greater than the second coercive field strength and, after leaving the second point, falls below the first coercive field strength and, during the movement of the measurement object from the second to the third point, no longer rises over the first coercive field strength and the field direction of the premagnetising field at the second point points in a first direction and
- the field strength of the premagnetising field falls below the second coercive field strength when it reaches the third point and, during the movement of the measurement object from the third to the sensor line (2), no longer rises over the second coercive field strength and the field direction of the premagnetising field points in a second direction at the third point, which differs from the first direction, **characterised in that,** as a premagnetising magnet, a premagnetising magnet (6, 7) is used for premagnetising magnetic materials on a measuring object, which, after the premagnetisation, is supplied to a sensor line (2) of a measuring device to measure the magnetic properties of the environment of the measuring device, during which the magnetisation of the premagnetising magnet (6, 7) is not homogeneous, wherein the premagnetising magnet is a Halbach array.

2. Method according to claim 1, **characterised in that** the dipole moments of the individual magnet parts in the total sum substantially cancel themselves out so that the magnetic field consists substantially of multipole moments only.

3. Method according to claims 1 or 2, **characterised in that** a measuring device for measuring magnetic characteristics of the environment of the measuring device with a sensor line with at least one magneto resistive sensor element is used, extending in the direction of a line which can measure the magnetic properties in its environment, wherein the premagnetising magnet (6, 7) is a part of the measuring device.

4. Method according to any one of the claims 1 to 3, **characterised in that** the premagnetising magnet (6, 7) has a height, a width and a length, wherein the length is greater than the height and is greater than the width and wherein the longitudinal extension of the premagnetising magnet (6, 7) is arranged parallel to the direction of the line.

5. Method according to any one of the claims 1 to 4, **characterised by** a first premagnetising magnet (6, 7) for the premagnetising of magnetic materials on a measurement object which, after premagnetising of a sensor line (2), is supplied to a measuring device for measuring magnetic characteristics of the environment of the measuring device, wherein the magnetising of the premagnetising magnet (6, 7) is not homogeneous and a second premagnetising magnet (6, 7) for the premagnetising of magnetic materials on a measurement object, which is supplied, after the premagnetising of a sensor line (2), to a measuring device for measuring the magnetic properties of the environment of the measuring device, wherein the magnetising of the premagnetising magnet (6, 7) is not homogeneous, wherein the second premagnetising magnet (6, 7) is arranged in a through direction pointing perpendicular to the longitudinal extension of the first premagnetising magnet (6, 7) and perpendicular to the line direction from the first premagnetising magnet (6, 7) behind the sensor line (2) or is arranged perpendicular to the through direction above the first premagnetising magnet (6, 7).

6. Method according to any one of the claims 1 to 5, **characterised in that** the sensor element (1) has a width and a length as well as a height, wherein the height is less than the width and the height is less than the length and the line direction points towards the width or towards the length of the sensor element (1) and creates a magnetic supporting field with a premagnetising device having the premagnetising magnet (6, 7) and a supporting field device (5) different from the premagnetising device, wherein said supporting field device extends in the area over which the sensor line (2) stretches, wherein the premagnetising magnet (6, 7) is arranged in a direction perpendicular to the direction of the line spaced away from the sensor line (2) and extending in a direction parallel to the direction of the line, wherein
- the magneto resistive sensor element (1) can measure substantially the magnetic properties of its environment only in a direction designated as the measuring direction of an orthogonal co-ordinate system or designated substantially only in a plane designated as a sensor measuring plane, stretched in two perpendicular measuring directions of an orthogonal co-ordinate system,
- with a premagnetising device consisting of only one premagnetising magnet (6, 7), the properties of the premagnetising magnet (6, 7) affecting the magnetic field generated by it and its arrangement relative to the sensor line (2) as well as the supporting field created by the supporting field device (5) are selected such that a superimposed magnetic field is created from superimposing the magnetic field generated by the premagnetising device and the supporting field whose strength of the field component pointing in the line direction, at least at one place on the sensor line (2), is greater than the strength of the field component, pointing perpendicular to the line direction and not in the direction of the height of the sensor element (1), or
- with a premagnetising device consisting of several premagnetising magnets (6, 7) the properties of the premagnetising magnets (6, 7) affecting the magnetic field generated by them and thearrangement of the premagnetising magnets (6, 7) relative to the sensor line (2) as well as the supporting field generated by the supporting field device (5) are selected such that an superimposed magnetic field arises from the superimposition of the magnetic field created by the premagnetising device and by the supporting field whose strength of the field components pointing in the direction of the line is greater, at least at a place on the sensor line (2), than the strength of the field components pointing perpendicular to the direction of the line and not in the direction of the height of the sensor element (1).

## Revendications

1. Procédé de pré-magnétisation de matériaux magnétiques sur un objet à mesurer avec un premier matériau magnétique avec un premier champ coercitif et un deuxième matériau magnétique avec un deuxième champ coercitif inférieur au premier champ coercitif, l'objet à mesurer étant amené après la pré-magnétisation d'une ligne de détecteurs (2) à un dispositif de mesure pour mesurer les propriétés magnétiques de l'environnement du dispositif de mesure, l'objet à mesurer étant guidé à un dispositif de pré-magnétisation d'un premier point à un deuxième point et puis à un troisième point à travers un champ de pré-magnétisation, le dispositif de pré-magnétisation présentant au moins un aimant de pré-magnétisation, dans lequel
- l'intensité de champ du champ de pré-magnétisation au premier point est supérieure au premier et au deuxième champs coercitifs,
- l'intensité de champ du champ de pré-magnétisation au deuxième point est supérieure au deuxième champ coercitif et, après avoir quitté le deuxième point, descend au-dessous du premier champ coercitif et ne monte plus au-dessus du premier champ coercitif pendant le déplacement de l'objet à mesurer du deuxième point vers le troisième et la direction du champ du champ de pré-magnétisation au deuxième point est orientée vers une première direction et
- l'intensité de champ du champ de pré-magnétisation à l'arrivée au troisième point descend au-dessous du deuxième champ coercitif et ne monte plus au-dessus du deuxième champ coercitif pendant le déplacement de l'objet à mesurer du troisième point vers la ligne de détecteurs (2) et la direction du champ du champ de pré-magnétisation au troisième point est orientée vers une deuxième direction, différente de la première direction, **caractérisé en ce qu'en** tant qu'aimant de pré-magnétisation un aimant de pré-magnétisation (6, 7) est utilisé pour la pré-magnétisation de matériaux magnétiques sur un objet à mesurer amené après la pré-magnétisation d'une ligne de détecteurs (2) à un dispositif de mesure pour mesurer les propriétés magnétiques de l'environnement du dispositif de mesure, pour lequel la magnétisation de l'aimant de pré-magnétisation (6, 7) n'est pas homogène, l'aimant de pré-magnétisation étant un réseau de Halbach.

2. Procédé selon la revendication 1, **caractérisé en ce que** les moments dipolaires de chaque partie de l'aimant s'annulent pour l'essentiel au total, de telle sorte que le champ magnétique présente pour l'essentiel uniquement des moments multipolaires.

3. Procédé selon la revendication 1 ou 2, **caractérisé en ce qu'**un dispositif de mesure est utilisé pour mesurer les propriétés magnétiques de l'environnement du dispositif de mesure avec une ligne de détecteurs avec au moins un élément de détection magnéto-résistif qui s'étend dans une direction de ligne et est capable de mesurer des propriétés magnétiques dans son environnement, l'aimant de pré-magnétisation (6, 7) faisant partie du dispositif de mesure.

4. Procédé selon l'une quelconque des revendications 1 à 3, **caractérisé en ce que** l'aimant de pré-magnétisation (6, 7) présente une hauteur, une largeur et une longueur telles que la longueur est supérieure à la hauteur et à la largeur et que l'extension longitudinale de l'aimant de pré-magnétisation (6, 7) est parallèle à la direction de ligne.

5. Procédé selon l'une quelconque des revendications 1 à 4, **caractérisé par** un premier aimant de pré-magnétisation (6, 7) destiné à la pré-magnétisation de matériaux magnétiques sur un objet à mesurer guidé après la pré-magnétisation d'une ligne de détecteurs (2) à un dispositif de mesure pour mesurer les propriétés magnétiques de l'environnement du dispositif de mesure, la magnétisation de l'aimant de pré-magnétisation (6, 7) n'étant pas homogène, et par un deuxième aimant de pré-magnétisation (6, 7) destiné à la pré-magnétisation de matériaux magnétiques sur un objet à mesurer amené après la pré-magnétisation d'une ligne de détecteurs (2) à un dispositif de mesure pour mesurer les propriétés magnétiques de l'environnement du dispositif de mesure, la magnétisation de l'aimant de pré-magnétisation (6, 7) n'étant pas homogène, le deuxième aimant de pré-magnétisation (6, 7) étant disposé derrière la ligne de détecteurs (2) dans une direction de passage perpendiculaire à l'extension longitudinale du premier aimant de pré-magnétisation (6, 7) et perpendiculaire à la direction de ligne en partant du premier aimant de pré-magnétisation (6, 7) ou étant disposé perpendiculairement à la direction de passage au-dessus du premier aimant de pré-magnétisation (6, 7).

6. Procédé selon l'une quelconque des revendications 1 à 5, **caractérisé en ce que** l'élément de détection (1) présente une largeur, une longueur et une hauteur telles que la hauteur est inférieure à la largeur et la hauteur est inférieure à la longueur, et la direction de ligne est orientée dans la direction de la largeur ou dans la direction de la longueur de l'élément de détection (1) et avec un dispositif de pré-magnétisation présentant l'aimant de pré-magnétisation (6, 7) et un dispositif de production de champ de support (5), différent du dispositif de pré-magnétisation, qui produit un champ de support magnétique dans la zone au-dessus de laquelle s'étend la ligne de détecteurs (2), l'aimant de pré-magnétisation (6, 7) étant disposé à distance de la ligne de détecteurs (2) dans une direction perpendiculaire à la direction de ligne et s'étendant dans une direction parallèle à la direction de ligne, dans lequel
- l'élément de détection magnéto-résistif (1) est capable de mesurer les propriétés magnétiques de son environnement pour l'essentiel uniquement dans une direction d'un système de coordonnées orthogonal, désignée comme direction de mesure, ou pour l'essentiel uniquement dans un plan formé par deux directions de mesure perpendiculaires d'un système de coordonnées orthogonal, désigné comme plan de mesure,
- lorsqu'un dispositif de pré-magnétisation se compose d'un seul aimant de pré-magnétisation (6, 7), les propriétés de l'aimant de pré-magnétisation (6, 7) qui agissent sur le champ magnétique qu'il produit, et son agencement par rapport à la ligne de détecteurs (2), ainsi que le champ de support produit par le dispositif de production de champ de support (5), sont sélectionnés de sorte qu'un champ magnétique de superposition est formé par superposition du champ magnétique produit par le dispositif de pré-magnétisation et du champ de support, dont l'intensité de la composante de champ orientée dans la direction de ligne, au moins en un emplacement de la ligne de détecteurs (2), est supérieure à l'intensité de la composante de champ orientée perpendiculairement à la direction de ligne et non dans la direction de la hauteur de l'élément de détection (1), ou
- lorsqu'un dispositif de pré-magnétisation se compose de plusieurs aimants de pré-magnétisation (6, 7), les propriétés des aimants de pré-magnétisation (6, 7) qui agissent sur le champ magnétique qu'ils produisent, et l'agencement des aimants de pré-magnétisation (6, 7) par rapport à la ligne de détecteurs (2), ainsi que le champ de support produit par le dispositif de production de champ de support (5), sont sélectionnés de sorte qu'un champ magnétique de superposition est formé par superposition du champ magnétique produit par le dispositif de pré-magnétisation et du champ de support, dont l'intensité de la composante de champ orientée dans la direction de ligne, au moins en un emplacement de la ligne de détecteurs (2), est supérieure à l'intensité de la composante de champ orientée perpendiculairement à la direction de ligne et non dans la direction de la hauteur de l'élément de détection (1).
